# EUROPÄISCHE PATENTSCHRIFT

(11) **EP 0 824 774 B1**
(45) Veröffentlichungstag und Bekanntmachung des Hinweises auf die Patenterteilung: **21.07.1999**
(21) Anmeldenummer: 96910012.2
(22) Anmeldetag: 23.03.1996
(51) Int. Cl.: H01S 3/23, H01S 3/25

(54) **ANORDNUNG UND VERFAHREN ZUR FORMUNG UND FÜHRUNG EINES STRAHLUNGSFELDS EINES ODER MEHRERER FESTKÖRPER- UND/ODER HALBLEITERLASER(S)**
PROCESS AND DEVICE FOR FORMING AND GUIDING THE RADIATION FIELD OF ONE OR SEVERAL SOLID AND/OR SEMICONDUCTOR LASERS
PROCEDE ET DISPOSITIF DE FORMAGE ET DE GUIDAGE DU CHAMP DE RAYONNEMENT D'UN OU DE PLUSIEURS LASERS A SOLIDE ET/OU A SEMI-CONDUCTEUR

(30) Priorität: 26.04.1995 DE 19514626
(43) Veröffentlichungstag der Anmeldung: 25.02.1998
(73) Patentinhaber: Fraunhofer-Gesellschaft zur Förderung der angewandten Forschung e.V., 80636 München (DE)
(72) Erfinder: DU, Keming, D-52078 Aachen (DE); LOOSEN, Peter, D-52076 Kornelimünster (DE)
(86) Internationale Anmeldenummer: EP9601287
(87) Internationale Veröffentlichungsnummer: WO9634442

(56) Entgegenhaltungen:
- WO-A-95/15510
- WO-A-96/13884
- DE-A- 4 446 026
- US-A- 4 986 634
- CLEO-1994, 28.August 1994 - 2.September 1994, AMSTERDAM, Seiten 410-411, XP002006235 W.A.CLARKSON ET AL.: "DIODE LASER BAR BEAM SHAPING TECHNIQUE"
- OPTICS LETTERS, Bd. 20, Nr. 2, 15.Januar 1995, WASHINGTON US, Seiten 222-224, XP002006236 R.P.EDWIN: "STRIPE STACKER FOR USE WITH LASER DIODE BARS"

## Beschreibung

Die vorliegende Erfindung betrifft eine Anordnung zur Formung und Führung eines Strahlungsfelds eines oder mehrerer Festkörper- und/oder Halbleiterlaser(s), insbesondere eines Strahlungsfelds eines Arrays bzw. einer Feldanordnung aus einem oder mehreren Festkörper- und/oder Halbleiterlaser(n), mit einer Strahlungstransformationsoptik zur Erzeugung eines definierten Strahlungsfelds, wobei die Optik refraktive Elemente aufweist. Weiterhin betrifft die Erfindung ein Verfahren zur Formung und Führung eines Strahlungsfelds eines oder mehrerer Festkörper- und/oder Halbleiterlaser(s), insbesondere eines Strahlungsfelds eines Arrays bzw. einer Feldanordnung aus einem oder mehreren Festkörper- und/oder Halbleiterlaser(n), mit einer Strahlungstransformationsoptik zur Erzeugung eines definierten Strahlungsfelds, wobei die Optik refraktive Elemente aufweist.

Festkörper- und Halbleiterlaser haben in den vergangenen Jahren verstärkt Anwendung in der Materialbearbeitung und der Medizintechnik gefunden.

Ein weites Anwendungsgebiet der Festkörperlaser ist die Materialbearbeitung. Der Einsatzbereich von Festkörperlasern wird hierbei durch die erforderliche Wellenlänge der erzeugten Strahlung, die Leistung und die Form der Laser für das bestimmte Einsatzgebiet festgelegt. Da mit Festkörperlasern, insbesondere in niedrigen Leistungsklassen, hohe Strahlqualitäten erzeugt werden können, die in Verbindung mit kurzen Wellenlängen und entsprechenden Bearbeitungsoptiken sehr geringe Fokusdurchmesser ermöglichen, eröffnen sich den Festkörperlasern insbesondere Anwendungen bei schwierig zu bearbeitenden, hoch reflektierenden Materialien und bei Anwendungen, bei denen eine hohe Bearbeitungspräzision gefordert wird. Weiterhin sind als Vorteil die großen Frequenzbandbreiten der Festkörperlaser zu nennen, bei denen viele Moden, im Gegensatz beispielsweise zu Gaslasern, gleichzeitig schwingen. Als weiteres Merkmal eines Festkörperlasers ist dessen geringe Baugröße zu nennen, die bei einer typischen Länge von etwa 8 cm und einem typischen Durchmesser von 1 cm liegt. Anwendungsgebiete von Festkörperlasern im Bereich der Materialbearbeitung sind die Materialabtragung, das Bohren, das Trennen, das Fügen und das Schweißen.

Eine schnelle Weiterentwicklung haben in den letzten Jahren insbesondere Diodenlaser erfahren. Als typische Anwendungsgebiete sind die Materialbearbeitung sowie das Pumpen von Festkörperlasern aufzuführen.

Hochleistungslaserdioden besitzen typischerweise aktive Medien mit einem Querschnitt von 1 µm x 100 µm. Bedingt durch die Geometrie des aktiven Mediums ist die Strahlung, die von den Diodenlasern abgegeben wird, durch einen elliptischen Strahlquerschnitt und die große Divergenz in der schmalen Richtung und die relativ geringe Divergenz in der breiten Richtung bzw. der Verbindungsebene, als sogenannte Junction-Ebene bezeichnet, gekennzeichnet. Um mittels Diodenlasern höhere Leistungsdichten zu erzielen, ist es üblich, mehrere Laserdioden zu Laserdiodenfeldern- oder -arrays zusammenzufassen und deren Strahlung zu fokussieren. Zur Erzeugung von Strahlungsfeldern werden Laserdioden, sofern sie in einer Reihe angeordnet sind, mit der großen Achse ihres elliptischen Strahlquerschnitts parallel zueinander verlaufend angeordnet. Da die Strahlqualität in der schmalen Richtung beugungsbegrenzt ist und der in der Junction-Ebene ca. 1.000-fach beugungsbegrenzt ist, kann die von einem Laserdiodenarray emittierte Strahlung nicht mit zylindrischen Linsen und sphärischen Linsen oder einer Kombination hieraus in einen kleinen und kreisförmigen Fleck fokussiert werden, was die Anwendung z.B. zur Einkopplung der Strahlung in eine optische Faser oder das sogenannte "End-on-Pumpen" von Festkörperlasern in Verbindung mit einem Laserdiodenarry einschränkt.

Auch bei den angesprochenen Festkörperlasern, insbesondere bei solchen einer niedrigen Leistungsklasse unter Ausnutzung der hohen Strahlqualitäten, ist es ebenfalls erforderlich, zur Erzeugung ausgedehnter Strahlungsfelder mit einer hohen Leistungsdichte mehrere solcher Festkörperlaser zu Arrays bzw. Feldanordnungen zusammenzufügen.

Ein Problem, das sich bei großen Feldanordnungen aus Festkörperlasern und Diodenlasern stellt, ist die Abführung der beim Lasern entstehenden Wärme, was wiederum entsprechende Kühlmaßnahmen erfordert, so daß zwischen den einzelnen Festkörpern bzw. aktiven Medien Abstände verbleiben müssen, um Kühlkörper vorzusehen oder Kühlkanäle zur Durchführung von Kühlfluiden zu bilden. Solche Kühlmaßnahmen begrenzen natürlich stark die Packungsdichte, mit der die Laser zu Laserarrays bzw. -feldanordnungen zusammengefaßt werden können.

Da für solche Strahlungsfelder, die von aus Diodenlasern oder Festkörperlasern zusammengestellten Arrays bzw. Feldanordnungen erzeugt werden, in der Abbildungsebene, d.h. beispielsweise auf der Werkstückoberfläche, bestimmte Strahlgeometrien und Leistungsdichten gefordert werden, muß die Strahlung, die von jedem einzelnen Festkörperlaser bzw. Diodenlaser abgegeben wird, entsprechend geführt und geformt werden.

Aufgrund der extrem unterschiedlichen Strahlqualitäten solcher Diodenarrays in den beiden unterschiedlichen Richtungen, d.h. aufgrund der in der schmalen Richtung beugungsbegrenzten Strahlqualität und in der Junction-Ebene ca. 1000-fach beugungsbegrenzten Strahlqualität, kann die von einem Laserdiodenarray emittierte Strahlung nicht mit zylindrischen Linsen und sphärischen Linsen oder einer Kombination solcher optischen Bauteile in einen kleinen, kreisförmigen Fleck fokussiert werden. Dadurch sind derzeit die Anwendungen von Hochleistungsdiodenlasern auf Bereiche beschränkt, wo nur geringe Anforderungen an die Strahlqualität gestellt werden. Die Erweiterung der derzeitigen Anwendungen auf Gebiete wie die Medizintechnik und die Materialbearbeitung, die Faserkopplung und das End-on-Pumpen von Festkörper- und Faserlasern, erfordert Transformationen der Hochleistungsdiodenlaserstrahlung.

Gleiches gilt für die angeführten Festkörperlaser mit hoher Strahlqualität dann, wenn aus solchen einzelnen Festkörperlasern die entsprechenden großen Strahlungsfelder, die benötigt werden, erzeugt werden sollen.

Ausgehend von dem vorstehend angeführten Stand der Technik und der beschriebenen Problematik liegt der vorliegenden Erfindung die Aufgabe zugrunde, eine Anordnung und ein Verfahren anzugeben, mit denen die von Dioden- bzw. Festkörperlasern, d.h. aus diesen Lasern zusammengesetzte Diodenlaser- oder Festkörperlaser-Arrays, abgegebene Strahlung, oder aber die Strahlung, die von einem Laser, beispielsweise einem Diodenbarren, abgegeben wird (entsprechend in Strahlungsanteile unterteilt), mit einfachen und kostengünstigen Maßnahmen zu Strahlungsfeldern einer gewünschten Anordnung und Verteilung der Leistungsdichte transformiert werden können.

Die vorstehende Aufgabe wird bei einer Anordnung zur Formung und Führung eines Strahlenfelds der eingangs beschriebenen Art dadurch gelöst, daß das Strahlungsfeld in mindestens zwei Strahlungsgruppen gemäß einer Vorgabe gruppiert ist und jede Strahlungsgruppe mit vorgegebenen Koordinaten in ein ihr zugeordnetes refraktives Element eintritt, wobei jedes refraktive Element die jeweilige Strahlungsgruppe an mindestens einer seiner Flächen derart bricht, daß die Strahlungsgruppen mit relativ zueinander geänderten Ausgangs-Koordinaten und/oder Ausgangs-Ausbreitungsrichtungen aus den refraktiven Elementen derart austreten, daß das genannte Strahlungsfeld zu einem Strahlungsfeld einer gewünschten Anordnung und Verteilung der Leistungsdichte transformiert ist.

Verfahrensgemäß wird die vorstehende Aufgabe, ausgehend von einem Verfahren der eingangs beschriebenen Art, dadurch gelöst, daß das Strahlungsfeld in mindestens zwei Strahlungsgruppen gemäß einer Vorgabe gruppiert wird, daß jede so gebildete Strahlungsgruppe mit vorgegebenen Koordinaten in ein ihr zugeordnetes erstes refraktives Element eingestrahlt wird, wobei in jedem refraktiven Element die jeweilige Strahlungsgruppe an mindestens einer seiner Flächen derart gebrochen wird, daß die aus den ersten refraktiven Elementen austretenden Strahlungsgruppen in einer ersten Richtung gegenüber der eingestrahlten Richtung derart versetzt zueinander sind, daß das genannte Strahlungsfeld zu einem Strahlungsfeld einer gewünschten Anordnung und Verteilung der Leistungsdichte transformiert ist.

Mit der angegebenen Anordnung bzw. dem Verfahren ist es möglich, mittels einfacher, refraktiver Elemente unter Ausnutzung unterschiedlicher Eintrittswinkel der einzelnen Strahlungsgruppe in das jeweilige refraktive Element und/oder unterschiedlich langer Arbeitswege der einzelnen Strahlungsgruppen durch das refraktive Element an der Austrittsseite einen definierten Versatz zu erzeugen, so daß die jeweiligen Strahlungsgruppen mit relativ zueinander geänderten Koordinaten und/oder Ausbreitungsrichtungen austreten. Obwohl die einzelnen Diodenlaser und/oder Festkörperlaser und somit deren Strahlungsquerschnitte einen bestimmten Abstand zueinander haben, kann mit diesen refraktiven Maßnahmen nicht nur eine Umorientierung der Lage der einzelnen Strahlungsfelder austrittsseitig der refraktiven Elemente erzielt werden, sondern es ist in einfacher Weise möglich, die einzelnen Strahlungsfelder dichter zu legen und damit die Leistungsdichte pro Flächeneinheit zu erhöhen. Es wird ersichtlich, daß für eine solche Umorientierung und Veränderung der Leistungsdichteverteilung nur eine minimale Anzahl optischer Bauteile erforderlich ist, woraus sich wiederum ein kompakter Aufbau ergibt. Weiterhin kann mit der relativen Lage der Eintrittsseiten der refraktiven Elemente zu den einzelnen Festkörper- und/oder Halbleiterlasern sowie der Ausdehnung der refraktiven Elemente quer zur Ausbreitungsrichtung der Strahlung eine der erwünschten Abbildung und Leistedichtungsverteilung entsprechende Gruppierung vorgenommen werden. Dies bedeutet, daß zum Beispiel in das eine und/oder das andere refraktive Element die Strahlung eines oder mehrerer Laser (Einzelstrahlungsquelle) der Feldanordnung eingestrahlt wird, d.h. es wird bereits eingangsseitig der refraktiven Elemente eine Gruppierung der Strahlungsanteile des Strahlungsfelds vorgenommen. Die Anordnung eignet sich für beliebig gruppierte und aufgebaute Feldanordnungen aus Festkörper- und/oder Halbleiterlasern, d.h. linienförmigen Feldanordnungen bzw. Arrays oder aber beispielsweise einer Feldanordnung mit mehreren, übereinandergestapelten, linienförmigen Laserarrays aus mehreren einzelnen Lasern, die ein senkrecht zur Ausbreitungsrichtung zweidimensionales Strahlungsfeld erzeugen.

In einer Weiterbildung der Erfindung wird die aus den refraktiven Elementen austretende Strahlung gruppiert und tritt in ein ihr zugeordnetes zweites refraktives Element ein. Diese Gruppierung kann gegenüber der ersten Gruppierung, mit der die einzelnen Strahlungsanteile in die ersten refraktiven Elemente eintreten, geändert werden, oder aber es kann die ursprüngliche Gruppierung beibehalten werden, d.h. jedem ersten refraktiven Element ist jeweils ein zweites refraktives Element zugeordnet, in das diejenigen Strahlungsanteile eintreten, die auch durch das erste refraktive Element hindurchgeführt wurden. In den jeweiligen zweiten refraktiven Elementen wird die jeweilige Strahlungsgruppe dann so gebrochen, daß die Strahlungsgruppe mit gegenüber ihren Eintrittskoordinaten relativ zueinander geänderten Koordinaten und/oder Ausbreitungsrichtungen aus den weiteren refraktiven Elementen austreten. Dies bedeutet, daß sich austrittsseitig der zweiten refraktiven Elemente die austretenden Strahlungsgruppen in ihren relativen Koordinaten zueinander mit einer gegenüber der ersten Umorientierung geänderten Richtungskomponenten ausbreiten. Anders ausgedrückt wird die Strahlung, die von einer aus einzelnen Lasern zusammengesetzten Feldanordnung abgegeben wird, mit einer Ausdehnung senkrecht zur Strahlausbreitungsrichtung, d.h. in der x-y-Richtung, zunächst so in die refraktiven Elemente eingestrahlt, daß die einzelnen Strahlungsgruppen unterschiedlich so gebrochen werden, daß zunächst ein Versatz nach dem ersten refraktiven Element in der einen Ausbreitungsrichtung, d.h. beispielsweise in der x-Richtung, erzielt wird, die vorzugsweise senkrecht zu der größten Ausdehnung des Strahlungsfelds liegt, so daß austrittsseitig des ersten refraktiven Elements die einzelnen Strahlungsgruppen in dieser x-Richtung nebeneinanderliegend treppenstufenartig untereinander versetzt sind. Beispielsweise unter Beibehaltung dieser Gruppierung treten dann die versetzten Strahlungsgruppen jeweils in ein weiteres refraktives Element unter einem definierten Winkel, und einer Richtung ein, die eine zu der Einfallsrichtung auf das erste Element geänderte Richtungskomponente besitzt, so daß die einzelnen Strahlungsgruppen in den jeweiligen refraktiven Elementen derart gebrochen werden, daß sie austrittsseitig einen gegenüber der Eintrittsseite unterschiedlichen Versatz und/oder eine unterschiedliche Ausbreitungsrichtung nunmehr in der x-Richtung besitzen. Dies bedeutet wiederum, daß in einer Abbildungsebene dann die austrittsseitig des ersten refraktiven Elements treppenstufenartig versetzten Strahlungsanteile nunmehr untereinanderliegend zusammengeschoben sind und beispielsweise ein geschlossenes Strahlungsfeld bilden. Es wird anhand dieses Beispiels ersichtlich, daß aus einer beliebigen Anzahl einzelner Festkörper- und/oder Halbleiterlaser, gegebenenfalls gruppiert, unter Einsatz einer der Anzahl der Strahlungsgruppen entsprechenden Anzahl erster und zweiter refraktiver Elemente, eine Umorientierung und/oder Umgruppierung der Strahlungsanteile in den zwei Raumrichtungen senkrecht zu der ursprünglichen Ausbreitungsrichtung des Strahlungsfelds erzielt werden kann. Hierbei wird ein hoher Wirkungsgrad der Leistungseffektivität, ein kompakter Aufbau unter Verwendung einer minimalen Anzahl von optischen Komponenten und ein hoher Freiheitsgrad bei der Ordnung und Umorientierung der Strahlungsanteile erzielt.

Falls es erforderlich ist, werden zusätzliche Abbildungsoptiken eingesetzt, um, auch im Rahmen einer Gruppierung, die von den Einzelstrahlenquellen abgegebene Strahlung auf die Elemente abzubilden.

Um einen Versatz ausgangsseitig des jeweiligen refraktiven Elements zu erreichen, ist eine einfache Maßnahme diejenige, den einzelnen Strahlungsgruppen unterschiedlich lange Ausbreitungswege in den refraktiven Elementen zuzuordnen. Dies kann zum einen durch unterschiedliche Einfallswinkel der jeweiligen Strahlengruppe in das ihr zugeordnete refraktive Element erfolgen, oder aber die jeweiligen refraktiven Elemente können eine unterschiedliche Länge besitzen, so daß dadurch der Weg durch das jeweilige Element verlängert und damit der Versatz austrittsseitig vergrößert wird.

Um beispielsweise ein Strahlungsfeld, das aus zueinander gleichen Strahlungsgruppen aufgebaut ist, wie beispielsweise ein solches, bei dem jeweils eine Strahlungsgruppe der Strahlung von einem oder zwei Einzellaserquellen entspricht, werden, um eine gleichmäßige, abgestufte Umorientierung zu erreichen, die jeweiligen refraktiven Elemente so dimensioniert und relativ mit ihren Eintrittsflächen zu der Ausbreitungsrichtung der jeweiligen Strahlungsgruppe orientiert, daß unmittelbar benachbarte Strahlungsgruppen gleiche Differenzen ihrer Ausbreitungsweglängen aufweisen. Dadurch wird ein von Strahlungsgruppe zu Strahlungsgruppe gleicher Versatz austrittsseitig der refraktiven Elemente erzielt. In einer einfachen Ausführung sind, um einen solchen gleichmäßigen Versatz von refraktivem Element zu refraktivem Element zu erhalten, die Austrittsflächen der refraktiven Elemente und/oder der weiteren refraktiven Elemente treppenstufenartig zueinander versetzt, was wiederum bedeutet, die einzelnen refraktiven Elemente besitzen eine unterschiedliche Länge in Strahlausbreitungsrichtung. Weiterhin kann es zur Erzeugung eines gleichförmigen Versatzes der jeweiligen Strahlungsgruppen zueinander vorteilhaft sein, die Austritts- und/oder Eintrittsflächen der refraktiven Elemente und/oder der weiteren refraktiven Elemente so anzuordnen, daß sie in einer zueinander parallel verlaufenden Ebene liegen. Vorzugsweise sind aber die den Strahlungsgruppen jeweils zugeordneten Eintrittsflächen der refraktiven Elemente in einer Ebene liegend ausgerichtet und der treppenstufenartige Versatz an der Austrittsseite der refraktiven Elemente gebildet, da der Divergenzwinkel durch die Brechung innerhalb der refraktiven Elemente dann kleiner ist und dadurch die Gruppierung definierter erreicht werden kann, im Gegensatz zu dem Fall, bei dem der Versatz an der Eintrittsseite liegt.

Eine weitere, einfache Maßnahme, um den erwünschten Versatz aufgrund der unterschiedlichen Brechung der einzelnen Strahlungsgruppen in den refraktiven Elementen zu erzielen, ist diejenige, wenigstens einen Teil der refraktiven Elemente mit unterschiedlichen Brechungsindizes auszustatten, beispielsweise durch eine unterschiedliche Art eines für das refraktive Element einzusetzenden Glaskörpers oder durch eine unterschiedliche Dotierung eines Glaskörpers, vorzugsweise aus Quarzglas, das sich durch eine hohe Reinheit auszeichnet, als brechwerterhöhende oder brechwerterniedrigende Maßnahme. Hierbei kann wiederum eine gleichförmige Abstufung zur Erzeugung eines gleichförmigen Versatzes benachbarter Strahlungsgruppen von Vorteil sein, indem jeweils benachbarte refraktive Elemente unterschiedliche Brechungsindizes aufweisen, die vorzugsweise unter gleichen Verhältnissen zu- oder abnehmen.

Um zu verhindern, daß Strahlungsanteile eines refraktiven Elements in jeweils benachbarte refraktive Elemente eintreten, werden benachbarte refraktive Elemente voneinander durch eine Schicht getrennt, die ein gegenüber dem angrenzenden refraktiven Element geringeren Brechungsindex aufweist. Strahlungsanteile in einem refraktiven Element, die aufgrund des Divergenzwinkels der Strahlung in die Randzone des refraktiven Elements gelangen, werden dann zur Mitte des refraktiven Elements hin durch Totalreflexion reflektiert.

Wie bereits vorstehend ausgeführt ist, wird mit dem Einsatz der refraktiven Elemente zur Veränderung der Koordinaten der eintretenden Strahlungsgruppen zueinander und/oder zur Änderung der Ausbreitungsrichtungen eine sehr einfache Möglichkeit gegeben, die angestrebten Strahlungsfelder und Leistungsdichten zu erzielen. Um der Strahlung, die aus einem refraktiven Element austritt, zusätzlich zu der Richtung, in der die Strahlung in den refraktiven Elementen gebrochen wird, eine zusätzliche Richtungskomponente zu verleihen, sind solche refraktiven Elemente von Vorteil, bei denen die Eintritts- und/oder die Austrittsflächen zum einen senkrecht auf einer gemeinsamen Ebene stehen, zum anderen aber um Achsen, die in der Ebene dieser Flächen und parallel zueinander verlaufen, zueinander verschwenkt sind. Durch diese unterschiedliche Ausrichtung der Eintritts- und/oder der Austrittsflächen, vorzugsweise in einer Richtung senkrecht zu der Richtung, in der die Strahlung gebrochen wird, wird die Ausbreitungsrichtung der einzelnen Strahlungsgruppen zueinander und damit deren Koordinaten zueinander geändert. Darüberhinaus besteht die Möglichkeit, diese Flächen geringfügig konkav oder konvex zu wölben, um die jeweilige Strahlung der Strahlungsgruppen aufzuweiten oder zu fokussieren. Eine weitere, einfache Möglichkeit, ein Strahlungsfeld in einer Richtungskomponenten aufzuweiten, ist dann gegeben, wenn die Eintritts- und/oder Austrittsflächen der refraktiven Elemente jeweils senkrecht auf einer gemeinsamen Ebene stehen und um Achsen, die in der Ebene dieser Flächen und parallel zueinander verlaufen, zueinander verschwenkt sind. Solche Maßnahmen können sowohl bei den jeweils ersten refraktiven Elementen als auch bei den jeweils zweiten refraktiven Elementen vorgenommen werden, wobei allerdings diese Maßnahme vorzugsweise an den zweiten refraktiven Elementen angewandt wird, und zwar dort wiederum bevorzugt an den Strahlungs-Austrittsflächen.

Wie bereits vorstehend erläutert wurde, stellt ein grundsätzlicher Nachteil einer Feldanordnung bzw. eines Arrays aus einzelnen Festkörperlasern und/oder Diodenlasern deren geringer Füllfaktor dar. Als Füllfaktor ist beispielsweise in einer Austrittsebene, in der die Austrittsfenster der einzelnen Laser liegen, die Summe der Querschnittsflächen der einzelnen Laserstrahlen bezogen auf die Gesamtfläche, die durch die Austrittsfenster der Feldanordnung aufgespannt wird, zu verstehen. In vielen Anwendungen ist es erwünscht, zum einen einen sehr gleichförmigen Füllfaktor zu erzielen, d.h. die mit der Laserstrahlung bestrahlte Fläche soll mit einer gleichförmigen Intensität in allen Flächenbereichen bestrahlt werden, wobei dann eine Maßnahme dahingehend anzuwenden ist, daß dann, wenn die Querschnittsabmessungen der Strahlungsanteile einzelner Strahlungsgruppen kleiner als die Breite des zugeordneten refraktiven Elements ist, die jeweilige Strahlungsgruppe in die Eintrittsfläche des jeweiligen refraktiven Elements unter einem Einfallswinkel ungleich 0° derart eintritt, daß annähernd die gesamte Breite der Eintrittsfläche des refraktiven Elements ausgeleuchtet ist. Diese Maßnahme wird vorzugsweise dann angewandt, wenn das refraktive Element aus einem einzelnen, zusammenhängenden Körper gebildet ist.

Um entweder gleichförmige Strahlungsfelder mit einer relativ großen Ausdehnung zu erzeugen oder um einen kleinen Strahlungsfleck hoher Strahlungsdichte in der Arbeitsebene zu erhalten, werden mehrere streifenförmige Strahlungsfelder, die aus einzelnen Lasern aufgebaut sind, parallel zueinander ausgerichtet, so daß die Ausgangsstrahlung durch eine Laser-feldanordnung abgegeben wird, die aus einer vorgegebenen Anzahl linienförmiger Laserarrays zusammengesetzt ist, wobei jedes linienförmige Laserarray aus einer Anzahl Einzellaser aufgebaut ist.

Während vorstehend Ausführungsformen erläutert wurden, bei denen die aus dem ersten refraktiven Element austretende Strahlung nach einer Gruppierung zweiten refraktiven Elementen zugeführt wird, wird in einer alternativen Ausführungsform die aus den refraktiven Elementen austretende Strahlung gruppiert und jede Strahlungsgruppe wird auf ein ihr zugeordnetes reflektives Element mit einer Reflexionsfläche gerichtet. Die einzelnen Reflexionsflächen, die jeweils einer Strahlungsgruppe dann zugeordnet sind, sind versetzt und/oder verkippt zu den anderen Reflexionsflächen angeordnet, daß die einzelnen Strahlungsgruppen mit gegenüber ihren Eintrittskoordinaten relativ zueinander geänderten Koordinaten und/oder Ausbreitungsrichtungen und/oder Orientierungen von den Reflexionsflächen abgestrahlt werden. Unter einer Orientierung in diesem Zusammenhang ist zu verstehen, daß der Strahlquerschnitt in Bezug auf die Strahlachse gegenüber der Orientierung vor dem Auftreffen auf die Spiegelfläche in einer Abbildungsebene beispielsweise um 180° gedreht ist. Eine solche Umorientierung kann ebenfalls zu einer Vergleichmäßigung des aus den einzelnen Lasern erzeugten Strahlungsfelds dienen.

Um wiederum eine stufenweise Umorientierung mit einer gewissen Symmetrie mittels der reflektiven Elemente zu erreichen, werden die einzelnen Reflexionsflächen jedes reflektiven Elements sequentiell in der Reihenfolge der einzelnen Strahlungsgruppen, wie sie nebeneinander liegen, versetzt.

Um den erwünschten Versatz mittels der einzelnen Reflexionsflächen zu erhalten, werden die Reflexionsflächen jeweils unter einem unterschiedlichen Abstand zu den ihnen zugeordneten Austrittsflächen der refraktiven Elemente angeordnet. Um den Versatz der einzelnen Spiegelflächen und die damit den Versatz der einzelnen Strahlungsgruppen zueinander in einer Relation zueinander zu bringen, sollten die Zentren der bestrahlten Reflexionsflächen auf einer Geraden liegen, so daß auch der Versatz und damit die in einer Ebene abgebildeten einzelnen Strahlengruppen eine linear zueinander versetzte Beziehung erhalten. Entsprechend den Maßnahmen, die dann angewandt werden, wenn in der zweiten Stufen weitere refraktive Elemente den ersten refraktiven Elementen zugeordnet werden, werden im Fall der ersten refraktiven Elemente und nachgeordneter reflektiver Elemente die Abstandsänderungen jeweils benachbarter Reflexionsflächen von gleicher Größe gewählt. Um insbesondere Strahlungsfelder aufbauen zu können, die durch aus einzelnen Diodenlasern zusammengesetzten Laser-Feldanordnungen erzeugt werden, die auf einem relativ kleinen Raum eine hohe Packungsdichte aufweisen können, werden die einzelnen Reflexionsflächen durch einen treppenstufenartigen Spiegel gebildet, der durch einfache Fertigungsmaßnahmen, trotz der geringen Abmessungen, herstellbar ist, beispielsweise indem die Treppenstufenflächen bzw. die Spiegelflächen in einen Spiegelkörper eingefräst werden.

Die einzelnen Reflexionsflächen können konkav oder konvex gekrümmte Flächen sein, um die Strahlquerschnitte der Strahlungsanteile, aus denen das Strahlungsfeld zusammengesetzt ist, zusätzlich aufzuweiten oder zu fokussieren. Krümmungen in Form von Zylindermantelsegmentflächen sind zu bevorzugen, um beispielsweise eine Fokussierung nur in einer Richtung, die beeinflußt werden soll, zu erreichen.

Um den Füllfaktor zu erhöhen, wird bei Strahlungsgruppen, deren jeweilige Querschnittsabmessungen ihrer Strahlungsanteile kleiner als die Breite des zugeordneten reflektiven Elements ist, die Strahlung der jeweiligen Strahlungsgruppe auf die Reflexionsfläche des jeweiligen reflektiven Elements unter einem Winkel ungleich 0° derart gerichtet, daß annähernd die gesamte Breite der Reflexionsfläche des refraktiven Elements ausgeleuchtet ist.

Hinsichtlich eines kompakten Aufbaus der Anordnung werden das einer Strahlungsgruppe jeweils zugeordnete erste refraktive Element und das jeweilige weitere refraktive Element zu einem Körper zusammengefügt, wobei die Gruppierung bzw. Umorientierung der einzelnen Strahlungsgruppen zwischen dem ersten refraktiven Element und dem zweiten refraktiven Element an einer entsprechend ausgebildeten Grenzfläche, die den Übergang zwischen diesen beiden refraktiven Elementen festlegt, gebildet wird. Hierdurch kann die gewünschte Strahlführung sowohl in der einen Richtung als auch in der anderen Richtung und damit die Änderung der jeweiligen Ausbreitungsrichtung und/oder der Koordinaten der Strahlungsgruppen zueinander durch ein einziges optisches Element erhalten werden. In gleicher Weise ist es möglich, die reflektiven Elemente auf den Strahlungs-Austrittsflächen des der jeweiligen Strahlungsgruppe zugeordneten refraktiven Elements in Form einer reflektiven Fläche aufzubringen, so daß auch in Bezug auf das erste refraktive Elemente mit nachgeordneten reflektiven Flächen eine Anordnung möglich ist, die aus einem einzelnen Körper gebildet ist. Solche Anordnungen aus nur einem Körper bringen den Vorteil mit sich, daß nach der Fertigung des Körpers keine weiteren Justiermaßnahmen der jeweiligen refraktiven Elemente und/oder der reflektiven Elemente erforderlich sind, sondern die Justierung einer solchen Anordnung nur relativ zu der Laser-Feldanordnung notwendig ist.

Im Rahmen der erfindungsgemäßen Strahlungstransformation wird jeweils angestrebt, daß nach dem letzten transformierenden Element - falls es erforderlich ist, können Transformationen mit mehr als zwei Elementen vorgenommen werden - die aus dem letzten Element austretenden bzw. reflektierten Strahlungsgruppen zueinander parallele Ausbreitungsrichtungen oder einen gemeinsamen Schnittpunkt haben.

Sowohl die refraktiven Elemente als auch die reflektiven Elemente besitzen ihre spezifischen Vorteile. Refraktive Elemente zeichnen sich dadurch aus, daß nur ein Körper erforderlich ist, um einen erforderlichen Versatz zwischen der Eintritts- und Austrittsfläche zu erzielen. Darüberhinaus kann bei refraktiven Elementen die Orientierung der Austrittsfläche so gewählt werden, daß an diesen Austrittsflächen ein weiterer Versatz der austretenden Strahlungsanteile erzielt wird. Weiterhin sind mit refraktiven Elementen hohe Belegungsdichten mit einer definierten Zuordnung der einzelnen refraktiven Elementen den jeweiligen Strahlungsanteilen möglich. Darüberhinaus können solche refraktiven Elemente so aufgebaut und angeordnet werden, daß die Strahlungsanteile jeweils mit gleichen Divergenzwinkeln in die Eintrittsflächen eintreten, so daß in etwa gleiche Verhältnisse erzielt werden. Schließlich ist ein Vorteil darin zu sehen, daß die Strahlung in den refraktiven Elementen geführt wird und sie somit in diesem Bereich keinen äußeren Störeinflüssen unterliegt. Reflektive Elemente, wie sie vorstehend aufgezeigt sind, erfordern jeweils nur eine Spiegel- bzw. Reflexionsfläche, die auf einfach herstellbaren Trägerkörpern, beispielsweise aus Kunststoff, aufgebracht werden können. Gerade in Bezug auf solche Kunststoffträger, die beispielsweise mittels Spritzgießtechniken hergestellt werden können, ergibt sich eine sehr kostengünstige Anordnung.

Um die Vorteile, die mit den Maßnahmen nach den einzelnen Ansprüchen, die vorstehend erläutert sind, besser zu verdeutlichen sowie weitere Merkmale der Erfindung aufzuzeigen, werden nun verschiedene Ausführungsbeispiele der Erfindung anhand der Zeichnungen beschrieben.

In den Zeichnungen zeigen:
- Figuren 1A bis 1E: schematisch verschiedene ein- und zweidimensionale Laserarrays, in Verbindung mit denen die erfindungsgemäßen Anordnungen einsetzbar sind,
- Figuren 2A und 2B: eine erste Ausführungsform der erfindungsgemäßen Anordnung zur Formung und Führung eines Strahlungsfelds eines eindimensionalen, geradlinigen Laserarrays, das in den Figuren 1A oder 1B dargestellt ist, unter Verwendung eines ersten refraktiven Elements (Figur 2A) und eines nachgeordneten zweiten refraktiven Elements (Figur 2B),
- Figuren 3A und 3B: eine den Figuren 2A und 2B entsprechende Anordnung, wobei die refraktiven Elemente gegenüber der Ausführungsform der Figur 2 auf ihrer Austrittsseite die treppenstufenartig zueinander versetzte Austrittsflächen aufweisen,
- Figuren 4A und 4B: eine Ausführungsform ähnlich der Ausführungsform der Figuren 3A und 3B mit zusätzlichen reflektiven Flächen austrittsseitig der refraktiven Elemente,
- Figuren 5A und 5B: eine Anordnung unter Verwendung erster refraktiver Elemente (Figur 5A) und nachgeordneter reflektiver Elemente (Figur 5B),
- Figur 6: einen Stapel refraktiver Elemente in Form einzelner Glasplatten, wobei zu den einzelnen Platten in der unteren Graphik quer zur Erstreckung der Glasplatten der Brechungsindex aufgetragen ist,
- Figuren 7A und 7B: refraktive Elemente, die durch einzelne Glasplatten gebildet sind, wobei jede Glasplatte einen unterschiedlichen Brechungsindex aufweist,
- Figur 8A: eine Ansicht auf die Anordnung der Figuren 7A und 7B aus Richtung des Pfeils VIIIA in den Figuren 7A und 7B,
- Figur 8B: eine Draufsicht auf die Anordnungen der Figur 8A aus Richtung des Sichtpfeils VIIIB in Figur 8A,
- Figuren 9A und 9B: zu den Figuren 8A und 8B entsprechende Darstellungen, wobei im Gegensatz zu den Figuren 8 die einzelnen Strahlen der Strahlungsgruppen in unterschiedlichen Höhen in das jeweilige refraktive Element eintreten und unter einer gleichen Höhe aus dem jeweiligen refraktiven Element austreten,
- Figur 10: schematisch eine seitliche Darstellung einer Anordnung, mit der die einzelnen Strahlungsgruppen in einem Glasplattenstapel entsprechend der Figur 7A mehrfach gefaltet werden,
- Figur 11A: eine erfindungsgemäße Anordnung, die zur Erhöhung der Beleuchtungsdichte bzw. des Füllfaktors dient,
- Figur 11B: schematisch die Strahlungsquerschnittsverteilung des Strahlungsfelds eingangsseitig und ausgangsseitig der Anordnung der Figur 11A,
- Figur 12: eine perspektivische Anordnung einer Treppenstufenspiegelanordnung zur Erhöhung des Füllfaktors,
- Figur 13: die Anordnung der Figur 13, wobei jedem Treppenstufenspiegel ein lineares Laserarray zugeordnet ist,
- Figur 14: die Anordnung nach der Figur 13, wobei den einzelnen treppenförmigen Spiegelelementen jeweils eine lineare Laser-Feldanordnung zugeordnet ist,
- Figur 15 und Figur 16: jeweils einen Treppenstufenspiegel mit konkav gekrümmten Spiegelflächen,
- Figuren 17A und 17B: eine Anordnung mit ersten refraktiven Elemente (Figur 17A) und zweiten refraktiven Elementen (Figur 17B), wobei den drei jeweiligen refraktiven Elementen eine Feldanordnung aus drei Reihen mit jeweils drei Einzellasern zugeordnet sind,
- Figur 18: einen Treppenstufenspiegel, bei dem die einzelnen Spiegelflächen um eine gemeinsame Achse jeweils um einen gleichen Winkel zueinander verschwenkt sind,
- Figur 19: eine weitere Ausführungsform eines Treppenstufenspiegels, bei dem die einzelnen Spiegelflächen einen unterschiedlichen Versatz zueinander haben und unterschiedlich zueinander geneigt sind,
- Figuren 20A und 20B: ein refraktives Element (Figur 20A) und ein reflektives Element (Figur 20B), mit denen das Strahlungsfeld eines linearen Laserarrays in drei Strahlungsanteile gruppiert und zu einem annähernd runden Strahlungsfeld geformt wird, und
- Figur 21: schematisch einen weiteren Treppenstufenspiegel mit einer weiteren, beispielhaften Gruppierung der Strahlungsfelder.

Die erfindungsgemäße Anordnung in den verschiedenen möglichen Ausführungsformen ist zur Formung und Führung eines Strahlungsfelds eines Arrays bzw. einer Feldanordnung geeignet, die aus mehreren Festkörper- und/oder Halbleiterlasern zusammengesetzt ist. Sie ist aber auch zur Formung eines Strahlungsfelds, das von einem einzelnen Laser abgegeben wird, geeignet, beispielsweise für die Strahlung eines Diodenbarrens mit einem langgestreckten Strahlungsfeld, das umgeordnet bzw. transformiert werden soll.

Da einzelne Laserstrahlquellen in Form von Festkörper- und Diodenlasern nur begrenzt zu höheren Leistungen skalierbar sind, wird zum Erzielen höherer Laserleistungen und Leistungsdichten eine größere Anzahl einzelner Laserstrahlenquellen zu verschiedenen Arrays- oder Feldanordnungen zusammengefaßt. Verschiedene dieser Feldanordnungen sind in den Figuren 1A bis 1E dargestellt.

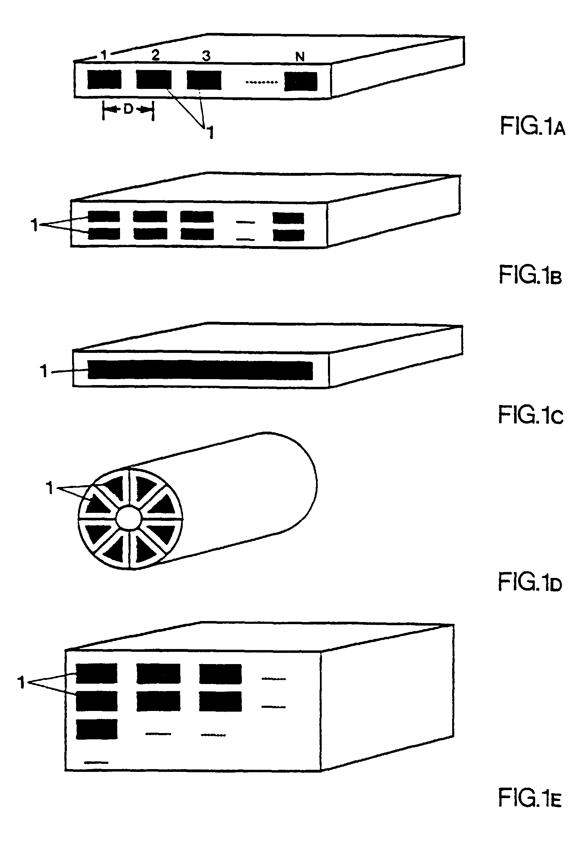

Hierbei kann man lineare Feldanordnungen, wie sie in den Figuren 1A und 1C dargestellt sind, doppelt-lineare Feldanordnungen, wie dies beispielsweise in Figur 1B dargestellt ist, radiale Feldanordnungen entsprechend der schematischen Darstellung der Figur 1D sowie zweidimensionale Arrays gemäß der schematischen Darstellung der Figur 1E unterscheiden.

Ein lineares Array, wie es die Figur 1A darstellt, weist N-Einzelstrahlungsquellen auf, so daß sich eine langgestreckte, lineare Strahlungsverteilung ergibt. Nachteilig ist die lineare Geometrie für solche Fälle, in denen kreisförmige oder quadratische Strahlungsflächen mit einem hohen Füllfaktor in einer Abbildungs- oder Bearbeitungsebene erzielt werden sollen.

Soweit im Rahmen dieser Beschreibung der Begriff "Füllfaktor" verwendet wird, so ist hierunter die Strahlquerschnittsfläche der einzelnen Strahlungsquellen, in den Figuren 1 mit dem Bezugszeichen 1 bezeichnet, zu der Gesamtfläche, die durch die Einzelstrahlungsquellen 1 aufgespannt wird, zu verstehen.

Ein Nachteil eines linearen Arrays gemäß Figur 1A aus Einzelstrahlungsquellen ist derjenige, daß in der Längsrichtung die Strahlqualität mindestens um einen Faktor N gegenüber der Einzelstrahlungsquelle verringert ist. Bei einer eindimensionalen, linearen Anordnung liegt daher eine gewisse Asymmetrie der Emission des Strahlungsfelds hinsichtlich der Querschnittsgeometrie und der Strahlqualität vor, die in einem Maße ansteigt, wie versucht wird, die Anzahl der Einzelstrahlungsquellen und damit die Gesamtleistung zu erhöhen. Zweidimensionale Arrays entsprechend der Figur 1B, oder insbesondere Arrays, die aus mehr als zwei linearen Einzelarrays zusammengesetzt sind, wie dies in der Figur 1E dargestellt ist, weisen den Nachteil der geringen Zugänglichkeit der inneren Einzelstrahlungsquellen 1 auf, um diese beispielsweise zu kühlen (Diodenlaser) oder anzuregen (Festkörperlaser). Um die Kühlmaßnahmen und die erforderlichen Maßnahmen zur Anregung zu erfüllen, müssen die Abstände D (siehe Figur 1A) der Einzelstrahlungsquellen zueinander vergrößert werden, wodurch natürlich der Füllfaktor am Ort der Strahlungsemission herabgesetzt wird.

Eine weitere Möglichkeit, den Füllfaktor zu erhöhen, ist mit einer Anordnung gegeben, die in der Figur 1D dargestellt ist. Die einzelnen Quellen 1 besitzen einen kreissegmentförmigen Emissionsquerschnitt, die um eine zentrale Achse herum angeordnet sind.

Wie anhand der Figuren 1A bis 1E veranschaulicht ist, ist es für hohe Strahlungsleistung und hohe Strahlungsdichten sowie große Füllfaktoren alleine nicht ausreichend, die Anzahl der Einzelstrahlungsquellen zu erhöhen, da auch eine mehrdimensionale Anordnung von Einzelstrahlungsquellen ihre Grenzen besitzt. Größere Feldanordnungen erfordern zum Beispiel, um die innenliegenden Strahlungsquellen entsprechend zu versorgen, größere Abstände D der Einzelstrahlungsquellen 1.

Soweit die einzelnen, nachfolgend beschriebenen Ausführungsbeispiele identische oder vergleichbare Bauteile aufweisen, so sind diese Bauteile und Elemente mit denselben Bezugszeichen bezeichnet und eine sich wiederholende Beschreibung dieser Teile wird nicht vorgenommen, so daß die Beschreibung dieser Teile anhand des einen Ausführungsbeispiels analog auf das jeweils andere Ausführungsbeispiel zu übertragen ist.

Um weitgehendst von der Anordnung der Einzelstrahlungsquellen unabhängig zu sein, ist es somit erforderlich, die Strahlung der einzelnen Strahlungsquellen 1 mittels nachgeordneter optischer Anordnungen in ihren Koordinaten relativ zueinander und/oder in der Ausbreitungsrichtung der einzelnen Strahlen zueinander und/oder der Orientierung des Einzelstrahls so zu verändern, daß bei vorgegebenem Aufbau einer Feldanordnung aus mehreren Festkörper- und/oder Halbleiterlasern definierte Strahlungsfelder in einer Abbildungsebene erzeugt werden können.

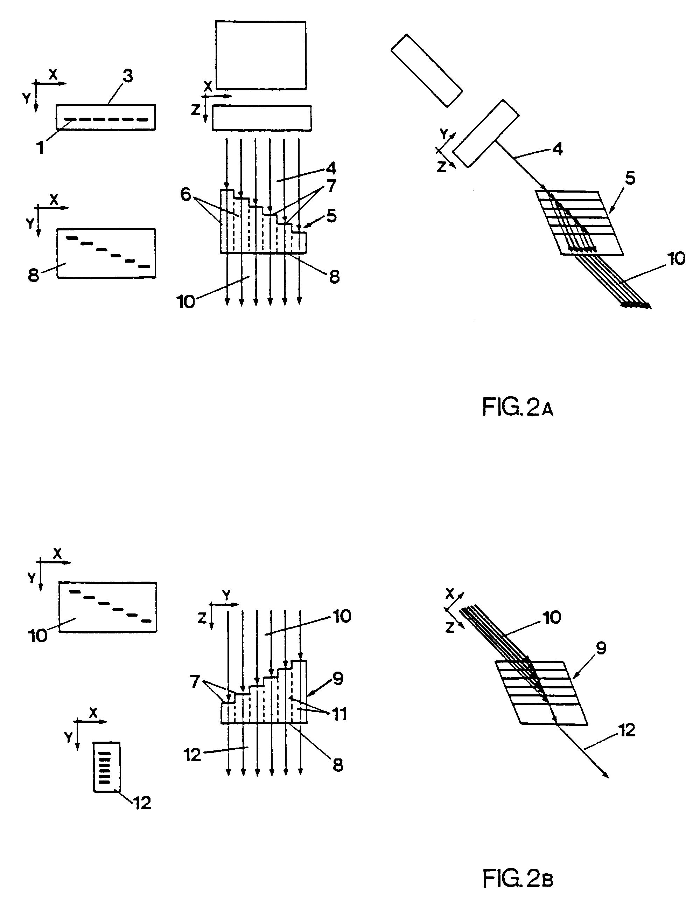

Gemäß einer ersten Ausführungsform der Erfindung, die in den Figuren 2A und 2B dargestellt ist, wird die von einer Festkörper- oder einer Halbleiterlaser-Feldanordnung 1, die eine lineare Anordnung aus sechs Einzelstrahlungsquellen 1 ist, wie dies auch vergrößert in der Figur 1A dargestellt ist, ausgehende Strahlung 4 auf ein erstes Element 5 gerichtet, das aus einzelnen, ersten refraktiven Elementen 6 aufgebaut ist, die jeweils durch parallel zur Strahlrichtung verlaufende, unterbrochene Linien angedeutet sind. Die einzelnen Strahlungsanteile, die durch jede Einzelstrahlungsquelle 1 erzeugt werden, können gruppiert werden, und entsprechend der Vorgaben wird jede Strahlungsgruppe in ein ihr zugeordnetes erstes refraktives Element 6 eingestrahlt. In der Ausführungsform, die in Figur 2A dargestellt ist, ist jeder Einzelstrahlungsquelle jeweils ein refraktives Element 6 zugeordnet, d.h. in dem Beispiel ist das erste Element 5 aus sechs einzelnen refraktiven Elementen 6 zusammengesetzt. Wie in der rechten Darstellung der Figur 2A zu sehen ist, fallen die einzelnen Strahlungsanteile 4 unter einem Einfallswinkel ungleich 0° auf die stirnseitigen Flächen der refraktiven Elemente 6 auf, so daß sie innerhalb der jeweiligen refraktiven Elemente gebrochen werden. Da die einzelnen refraktiven Elemente 6 einen gleichen Brechungsindex haben bzw. aus einem gleichen, transparenten Werkstoff hergestellt sind, erfahren die einzelnen Strahlungsanteile 4 einen gleichen Brechungswinkel an den Strahlungs-Eintrittsflächen 7 der refraktiven Elemente 6. Durch die unterschiedliche Länge der einzelnen refraktiven Elemente wird bewirkt, daß die einzelnen Strahlungsanteile einen unterschiedlich langen Weg durch das jeweilige refraktive Element 6 zurücklegen, so daß sie unter unterschiedlichen Höhen, verglichen mit der relativen Lage auf der Strahlungs-Eintrittsfläche 7, auf der Strahlungs-Austrittsfläche 8 austreten, wie dies in Figur 2A links unten dargestellt ist. Aufgrund des gleichen, treppenstufenartigen Versatzes zueinander an der Strahlungs-Eintrittsfläche 7 tritt an der Strahlungs-Austrittsfläche 8 ein jeweils gleicher Versatz der Strahlungsquerschnitte untereinander auf. Die einzelnen Strahlungsanteile werden dann auf ein zweites Element 9 zugeführt, wobei entsprechend der Gruppierung jedem Austrittsstrahl 10, der aus dem ersten Element 5 austritt, jeweils ein zweites reflektives Element 11, wiederum durch die unterbrochenen Linien in Figur 2B angedeutet, zugeordnet ist. Die einzelnen zweiten refraktiven Elemente 11 weisen, entsprechend dem ersten Element 5, treppenstufenartig abgestufte Strahlungs-Eintrittsflächen 7 auf, während die Strahlungs-Austrittsflächen 8 in einer gemeinsamen Ebene liegen. Allerdings ist die Abstufung der refraktiven Elemente 11 des zweiten Elements 9 entgegengesetzt der Abstufung der refraktiven Elemente 6 des ersten Elements von dem einen äußeren Strahlungsanteil zu dem anderen äußeren Strahlungsanteil gewählt. Somit werden die Gesamtausbreitungswege der jeweiligen Strahlungsanteile gleich lang gestaltet und können in einer gemeinsamen Ebene abgebildet werden.

An diesen zweiten refraktiven Elementen 11 erfolgt die Brechung aufgrund des Einfallswinkels der einzelnen Austrittsstrahlen 10 auf die Strahlungs-Eintrittsfläche 7 in einer Richtung, die um 90° zu der Einfallsrichtung der einzelnen Strahlungsanteile 4 auf das erste Element 5 gedreht ist. Hierdurch werden wiederum aufgrund der unterschiedlichen Wege der einzelnen Strahlungsanteile durch das jeweilige zweite refraktive Element 11 die einzelnen Strahlungsanteile derart gebrochen, daß die aus der Strahlungs-Austrittsfläche 8 des zweiten Elements 9 austretenden Austrittsstrahlen 12 versetzt austreten; dadurch werden die einzelnen Strahlungsquerschnitte übereinandergeschoben, wie dies in der linken, unteren Darstellung der Figur 2B zu sehen ist. Die Größe des Versatzes der Austrittsstrahlen 12 an der Strahlungs-Austrittsfläche 8 kann zum einen in Abhängigkeit des Brechungsindex des jeweiligen zweiten refraktiven Elements 11 und zum anderen über die Weglänge des jeweiligen Strahlungsanteils durch das ihm zugeordnete refraktive Element eingestellt werden. Wie die Figuren 2A und 2B zeigen, werden durch die beiden Elemente 5 und 9 bzw. deren erste refraktive Elemente 6 und deren zweite refraktive Elemente 11 die Strahlungsanteile zweimal so gebrochen, daß sie zum einen in der einen Richtung senkrecht zur Ausbreitungsrichtung unterschiedlich versetzt werden, während sie durch die zweiten refraktiven Elemente 11 in der Richtung, die sowohl senkrecht zur Ausbreitungsrichtung der Strahlungsanteile 10 und senkrecht zu der ersten Richtung der Brechung liegt, wieder übereinandergeschoben werden, so daß die Strahlungsquerschnitte, ausgehend von einer linearen Anordnung, zu einem dichten Strahlungsfeld hoher Strahlungsintensität zusammengeführt werden können. Basierend auf dem Prinzip, wie es in den Figuren 2A und 2B dargestellt ist, können andere Strahlgeometrien, ausgehend von einer linearen Anordnung, gebildet werden.

Die Anordnung der Figuren 2A und 2B besitzt einen besonderen Vorteil bei der Strahlungsformung und -führung eines Strahlungsfelds, das aus Diodenlasern zusammengesetzt ist. Typischerweise werden in einer linearen Feldanordnung einzelner Diodenlaser 24 Dioden über eine Länge von 1 cm integriert. Eine solche Laserdioden-Feldanordnung mit einem Strahlquerschnitt von 1 µm x 10 mm besitzt extrem unterschiedliche Strahlqualitäten in den beiden unterschiedlichen Richtungen ihres elliptischen Strahlquerschnitts. So ist die Strahlqualität in der schmalen Richtung, d.h. in der Junction-Ebene, ca. 1000-fach beugungsbegrenzt. Gerade in Verbindung mit einer solchen Laserdiodenfeldanordnung, bei der dann gemäß der Figur 2A jedem Emitter eine refraktive Stufe bzw. ein refraktives Element zugeordnet wird, werden in dem ersten Element 5 (treppenförmiger Glaskörper) laterale Versätze zwischen den Emittern in der y-Richtung erzeugt. Der Einfallswinkel, die Stufenhöhe und der Brechungsindex, wie dies noch nachfolgend erläutert wird, werden dann so untereinander abgestimmt, daß der Versatz zwischen den benachbarten Streifenemittern ein wenig größer als die Strahldimension in der y-Richtung wird. Das zweite Element 9 bzw. der zweite treppenförmige Glaskörper erzeugt dann Versätze, unter entsprechender Wahl der Einfallsrichtung der Strahlung auf die Strahlungs-Eintrittsfläche 7 und durch geeignete Wahl der Stufenhöhe, in der x-Richtung (Slow-Richtung). Durch geeignete Wahl der beeinflußbaren Faktoren des ersten Elements 5, d.h. des Brechungsindex, der Stufenhöhe und des Einfallswinkels, werden die Strahlungsanteile in der y-Richtung untereinander angeordnet. Die Strahlqualität entlang der y-Achse ist dann um einen Faktor der Emitteranzahl (in dem gezeigten Beispiel 6) verringert, und gleichzeitig erhöht sich die Strahlqualität in der Slow-Richtung (x-Richtung) um den gleichen Faktor. Dadurch werden die Strahlqualitäten in den beiden Richtungen vergleichbar sein und die Gesamtstrahlung der Diodenlaser-Feldanordnung kann in einen kreisförmigen oder rechteckigen Fleck fokussiert werden.

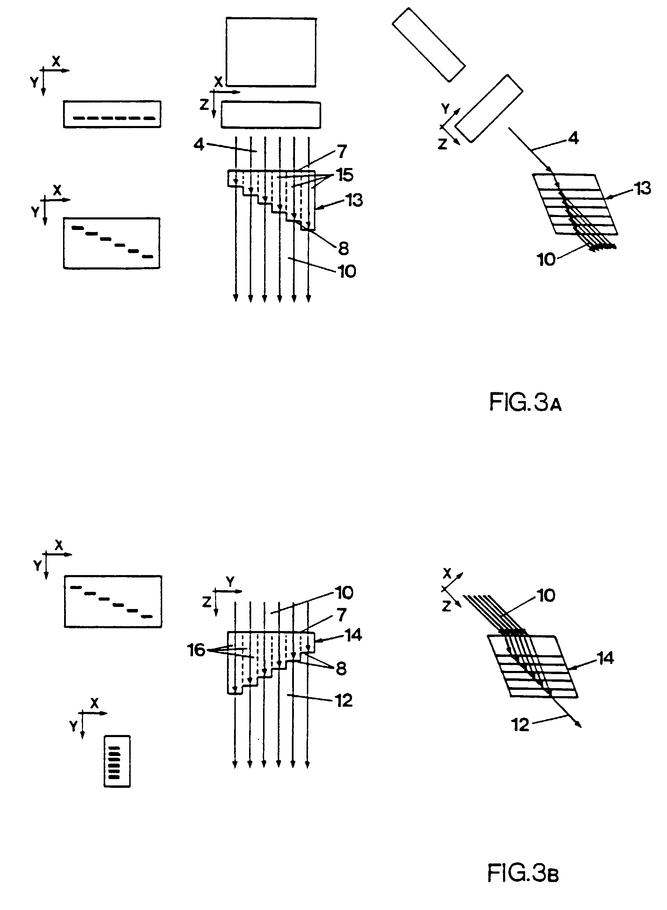

In den Figuren 3A und 3B ist eine Anordnung dargestellt, die mit der Anordnung der Figuren 2A und 2B vergleichbar ist. In dieser Ausführungsform der Figuren 3 sind das erste Element 13 und das zweite Element 14, aus einzelnen ersten und zweiten refraktiven Elementen aufgebaut, deren Strahlungs-Eintrittsflächen 7 jeweils in einer Ebene liegen, während die Strahlungs-Austrittsflächen 8 treppenstufenartig ausgeführt ist. Aufgrund der unterschiedlichen Wege der jeweiligen Strahlungsanteile durch das jeweils zugeordnete refraktive Element wird wiederum ein Versatz in einer ersten Richtung und und ein Versatz in einer zweiten Richtung erzeugt, so daß entsprechend der Figuren 2A und 2B ein Strahlungsfleck erzeugt wird. Der Ausführungsform des ersten und zweiten Elements 13 und 14 der Figuren 3A und 3B ist gegenüber der Ausführungsform der Figur 2 der Vorzug zu geben, da durch den gleichen Abstand zwischen den Austrittsfenstern der einzelnen Strahlungsquellen bis zu dem Eintritt in die Strahlungs-Eintrittsfläche des ersten Elements 13 eine exakte Gruppierung realisiert werden kann.

Anhand der Figuren 2 und 3 wird ersichtlich, daß in Abhängigkeit davon, welche Strahlungsmuster aus den einzelnen Strahlungsquerschnitten erzeugt werden sollen, die Treppenstufen auch in anderer Weise abgestuft werden können, beispielsweise auch derart, daß das refraktive Element mit der größten Ausdehnung in der Strahlrichtung in der Mitte des jeweiligen Elements angeordnet ist.

Darüberhinaus werden die refraktiven Elemente vorzugsweise aus einem einzelnen Glaskörper gearbeitet; eine weitere alternative Ausführungsform, die noch nachfolgend beschrieben wird, besteht darin, die einzelnen refraktiven Elemente aus Glasplatten zusammenzusetzen.

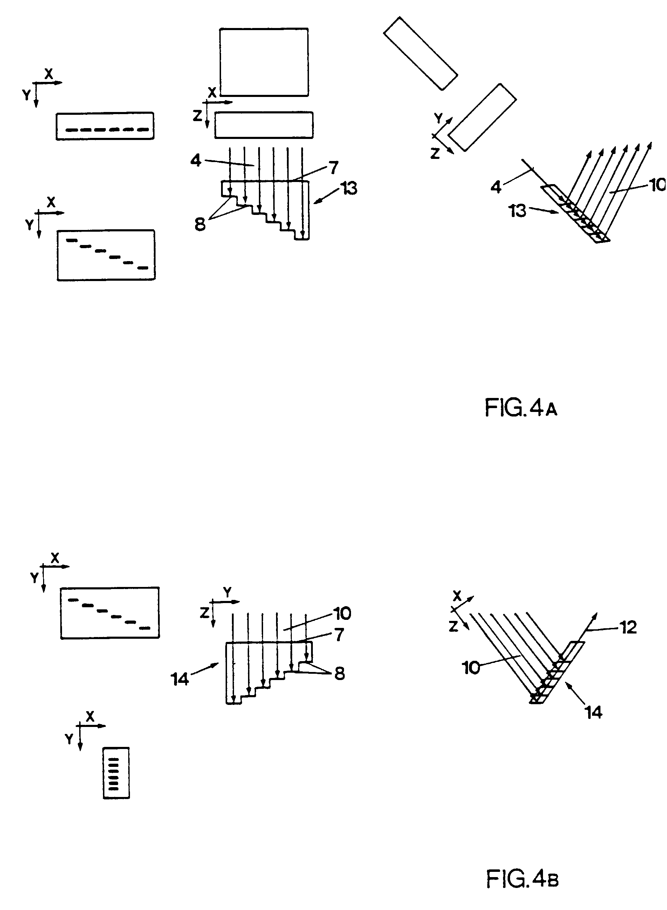

In den Figuren 4A und 4B ist eine Ausführungsform dargestellt, die wiederum von einer linearen Anordnung aus sechs Einzelstrahlungsquellen ausgeht. Im Gegensatz zu den Ausführungsformen nach den Figuren 3A und 3B sind in diesem Ausführungsbeispiel der Figuren 4A und 4B die Strahlungs-Austrittsflächen 8 verspiegelt. Hierdurch wird erreicht, daß die sich in den einzelnen refraktiven Elementen 15 ausbreitenden Strahlungsanteile auf diese verspiegelten Flächen auftreffen und, in Abhängigkeit des Winkels, mit dem sie auf diese Flächen auftreffen, reflektiert werden, so daß sie seitlich aus dem Element 13 austreten, wie dies in der rechten Darstellung der Figur 4A dargestellt ist. Während in der Figur 4A diese verspiegelten Endflächen 8 so dargestellt sind, daß sie parallel zu den Eintrittsflächen 7 verlaufen, kann der Ausbreitungsrichtung der an den Endflächen 8 reflektierten Strahlungsanteile 10 eine zusätzliche, geänderte Richtungskomponente durch eine geänderte Schrägstellung dieser Flächen verliehen werden. Auf diese Art und Weise kann die eintretende Strahlung 4 zum einen durch die unterschiedlich lange Ausbreitungsrichtung in den refraktiven Elementen 15 in einer Richtung transformiert werden, während sie durch die End-Spiegelflächen 8 mit einer anderen Richtungskomponenten transformiert werden. Entsprechend dem refraktiven Element 13 der Figur 4A weist das weitere refraktive Element 14 der Figur 4B, das in seinem grundsätzlichen Aufbau dem refraktiven Element 14 der Ausführungsform der Figur 3B entspricht, ebenfalls verspiegelte Endflächen 8 auf, so daß an diesen Endflächen 8 die einzelnen Strahlungsanteile reflektiert werden und seitlich austreten, und zwar in einer Richtung senkrecht zu der Richtung austrittsseitig des refraktiven Elements 13 der Figur 4A, wie in Figur 4B anhand der rechten Darstellung gezeigt ist und unter Vergleich der angegebenen Koordinaten ersichtlich ist.

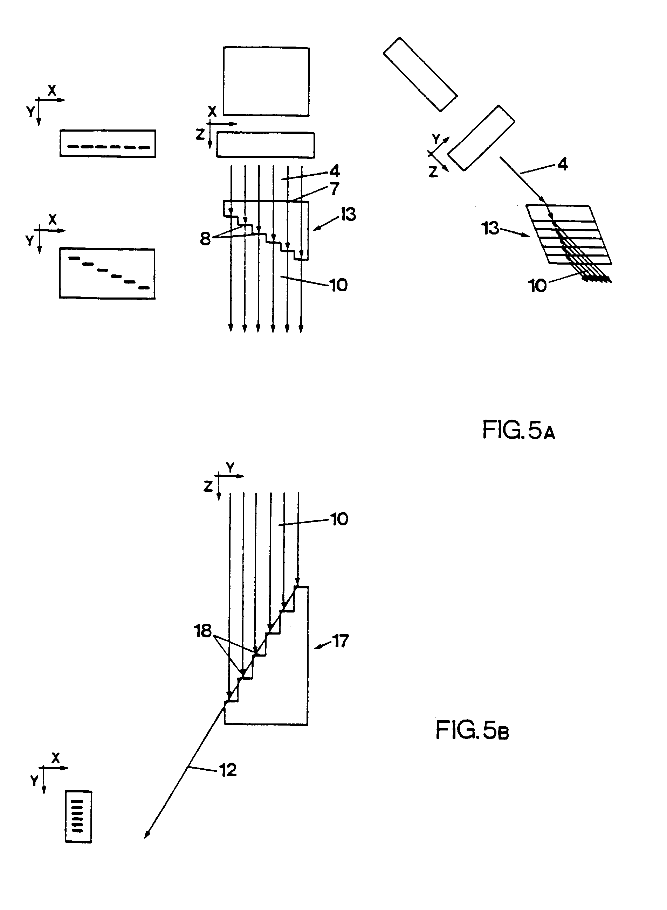

In den Figuren 5A und 5B ist eine weitere Ausführungsform dargestellt. Hierbei werden die aus den ersten refraktiven Elementen 6 (Figur 5A), die mit den refraktiven Elementen 15 des ersten Elements 13 der Figur 3A identisch sind, austretenden Strahlen 10 einem zweiten Element 17 (Figur 5B) mit einzelnen reflektiven Elementen in Form von Reflexionsflächen 18 zugeführt. Diese Reflexionsflächen 18 weisen zueinander treppenstufenförmig einen Versatz derart auf, daß die einzelnen aus dem ersten Element 13 austretenden Austrittsstrahlen 10 schräg auf die jeweilige Reflexionsfläche 18 auftreffen, derart, daß sie untereinander geschoben werden und ein zusammenhängendes Strahlungsfeld in einer Abbildungsebene erzeugen, wie dies in Figur 5B links dargestellt ist.

Zu den jeweils erzeugten Strahlungsfeldern ist anzuführen, daß zur Verdeutlichung der jeweiligen Änderung der Ausbreitungsrichtung der Strahlungsflächen die einzelnen Strahlungsquerschnitte mit einem entsprechenden Abstand zueinander dargestellt sind; allerdings können die Strahlen so zusammengeführt werden, daß ein zusammenhängendes Strahlungsfeld in der erwünschten Abbildungsebene erzeugt wird.

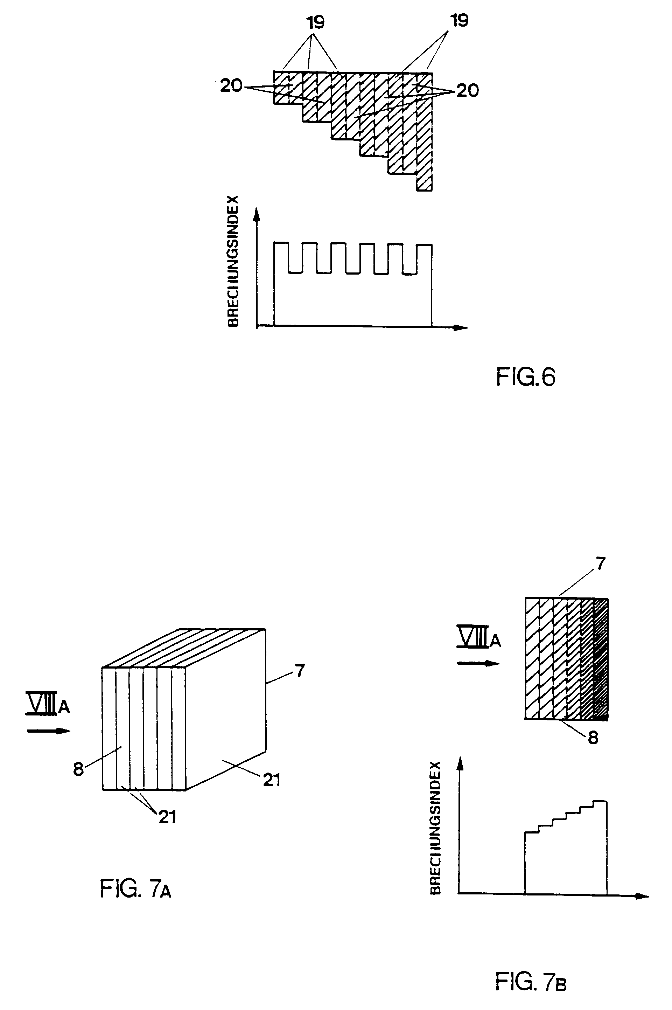

In Figur 6 ist schematisch eine Ausführungsform beispielsweise des ersten Elements 13 der Figuren 3A und 5A dargestellt, das aus einzelnen Glasplatten 19 (refraktive Elemente) aufgebaut ist. Jeweils benachbarte Glasplatten 19 sind durch eine weitere Glasplatte 20 getrennt, die gegenüber den Glasplatten 19 einen geringeren Brechungsindex aufweisen. Werden die einzelnen Strahlungsanteile in die Glasplatten 19 mit dem höheren Brechungsindex eingekoppelt, so werden sie in der Form eines Wellenleiters darin übertragen und geformt. Eine solche Maßnahme ist insbesondere für Laser-Feldanordnungen, bevorzugt für die Diodenlaser-Feldanordnungen, mit einer geringen Belegungsdichte bzw. einem geringen Füllfaktor von Vorteil, da auf diese Weise jedem einzelnen Diodenlaser genau ein refraktives Element zugeordnet werden kann und dadurch, durch den Füllfaktor bedingt, eine Verringerung der Strahlqualität weitgehendst vermieden werden kann.

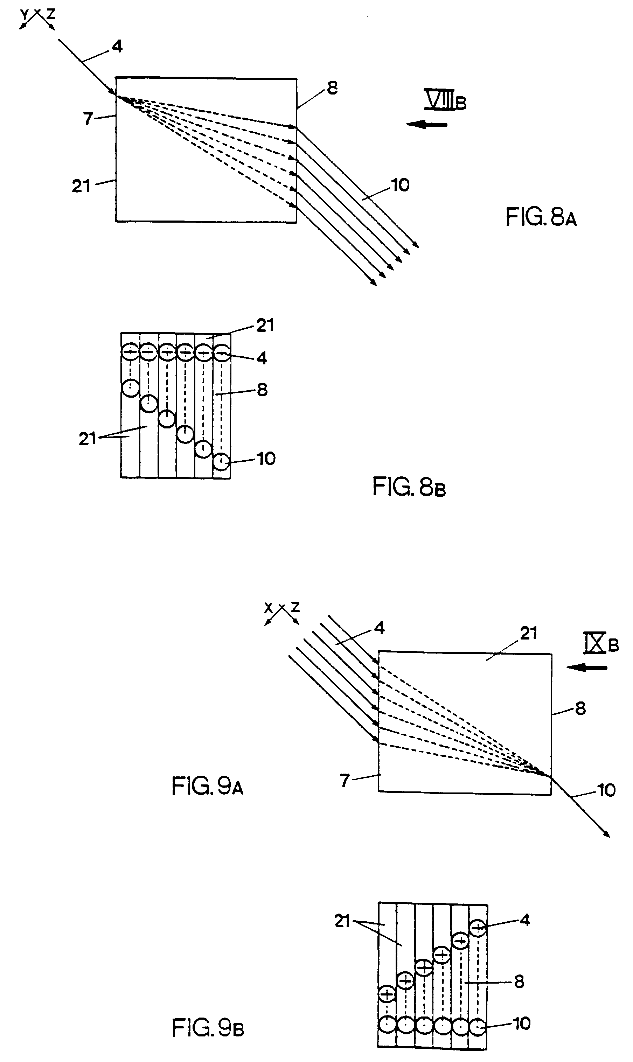

Die Figuren 7A und 7B zeigen eine Anordnung, die aus einzelnen Glasplatten 21 zusammengesetzt sind, die gleiche Außenabmessungen besitzen. Wie anhand der Figur 7B zu erkennen ist, weisen die einzelnen Glasplatten einen unterschiedlichen Brechungsindex auf, wobei der Brechungsindex der linken Platte am niedrigsten ist, während der Brechungsindex der rechten, äußeren Platte 21 am höchsten ist. Die Brechungsindizes sind in etwa gleichen Schritten zwischen den einzelnen Glasplatten 21 erhöht, wie das Diagramm der Figur 7B verdeutlicht. In der Anwendung wird jede Glasplatte 21 als refraktives Element jeweils einer Strahlungsgruppe eines Strahlungsfelds zugeordnet. Jede Strahlungsgruppe fällt auf die jeweilige Strahlungs-Eintrittsfläche 7, wobei es sich um die Stirnflächen der Glasplatten 21 handelt, unter einem Winkel ein, so daß die jeweiligen Teilstrahlen, je nach den Brechungsindizes, unterschiedlich gebrochen werden. Dieser unterschiedliche Strahlungsverlauf innerhalb der Glasplatten 21 ist in der Figur 8A und 8B verdeutlicht. Mit der Anordnung der einzelnen Glasplatten gemäß der Figuren 7 und 8 wird an der Strahlungs-Austrittsfläche 8 durch die Austrittsstrahlen 10 eine Strahlverteilung erzeugt, die wiederum, wie dies bereits anhand der früheren Ausführungsformen beschrieben ist, abgestuft bzw. treppenstufenartig zueinander versetzt ist, wie die Figur 8B erkennen läßt.

In den Figuren 9A und 9B ist eine Anordnung von Glasplatten 21 entsprechend der Figuren 7A und 8A in einer Seitenansicht dargestellt, wobei in dieser Ausführung die einfallende Strahlung 4 von Glasplatte zu Glasplatte 21 einen Versatz zueinander aufweist, wobei dann, aufgrund der abgestuften Brechungsindizes, die Austrittsstrahlen 10 auf gleicher Höhe liegen, wie dies auch in Figur 9B verdeutlicht wird. Die Figur 9A kann als Anschlußfigur zu der Figur 8A angesehen werden, wobei die Darstellung, wie anhand der Koordinaten der jeweils einfallenden Strahlen 4 ersichtlich wird, die Figur 9A gegenüber der Figur 8A um 90° gedreht ist, um die unterschiedlichen Ausbreitungswege in der gedrehten Richtung darzustellen.

Mit zwei aus einzelnen Glasplatten 21 aufgebauten Elementen, wie sie in den Figuren 8 und 9 dargestellt sind, kann bei einer Orientierung der Glasplattenstapel zueinander unter einem Winkel ungleich 0°, d.h. die Brechungen an den jeweiligen Glasplattenstapeln oder den ersten refraktiven Elementen und den zweiten refraktiven Elementen, die durch diese Glasplattenstapel gebildet werden, müssen in unterschiedliche Richtungen erfolgen, die einfallende Strahlung in zwei unterschiedlichen Richtungen transformiert werden.

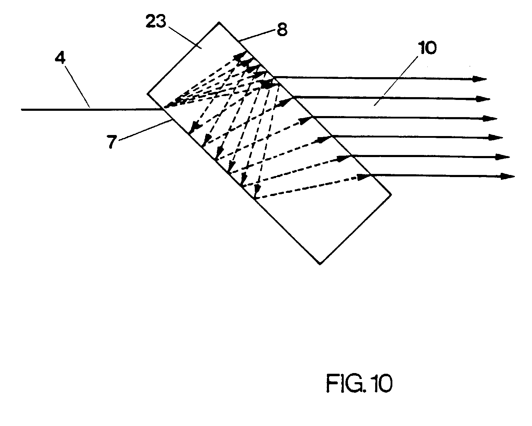

In der Figur 10 ist eine Ausführung in einer seitlichen Ansicht eines weiteren Glasplattenstapels, der aus einzelnen Glaskörpern 23 mit unterschiedlichen Brechungsindizes zusammengesetzt ist, dargestellt. Die auf eine Seitenfläche 7 der einzelnen Glaskörper 23 einfallende Strahlung 4 wird in dem jeweiligen Glaskörpern 23 jeweils mehrfach gefaltet und tritt aus den den Eintrittsflächen 7 gegenüberliegenden Austrittsflächen 8 mit einem entsprechenden Versatz aufgrund der unterschiedlichen Brechungsindizes der jeweiligen Glaskörper 23 aus. Die beiden Flächen 7 und 8 können geeignet reflektiv und transmissiv beschichtet sein. Durch diese Mehrfachfaltung werden die Ausbreitungswege innerhalb der Glaskörper 23 verlängert und somit die Versätze der austretenden Strahlungsanteile 10 zueinander trotz geringer Baugröße der Glaskörper 23 vergrößert.

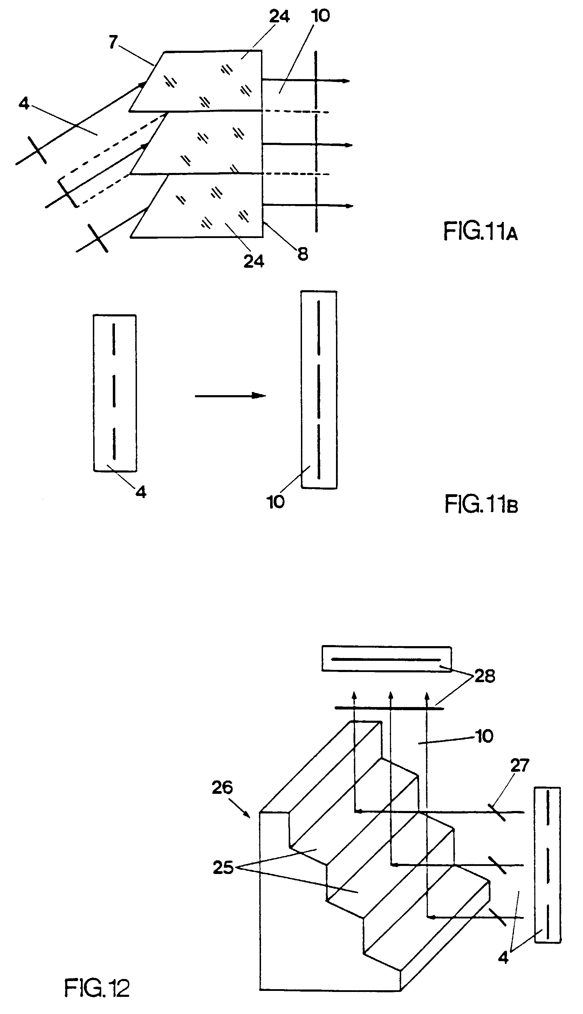

Betrachtet man Feldanordnungen, die aus Diodenlaserarrays aufgebaut sind, beispielsweise in der Form, wie sie in den Figuren 1B und 1E dargestellt ist, so beträgt der Füllfaktor thermisch bedingt etwa 30% bis 50% der durch die Einzelstrahlungsquellen aufgespannten Flächen. Dadurch verringert sich, wie bereits erläutert wurde, die Strahlqualität gegenüber einem theoretischen Fall einer Belegungsdichte von 100%. Um den Füllfaktor zu erhöhen und damit eine hohe Strahlqualität aufrechtzuerhalten, ist eine Anordnung aus refraktiven Elementen 24 von Vorteil, die in Figur 11A dargestellt ist. In diesem schematischen Beispiel sind drei refraktive Elemente 24 gestapelt. Die Eintrittsflächen sind, im Gegensatz zu den weiter vorstehend beschriebenen Ausführungsformen (plattenförmige, refraktive Elemente), abgeschrägt. Die einzelnen, eintretenden Strahlungsanteile 4 sind unter einem Winkel so auf die Strahlungs-Eintrittsflächen 7 gerichtet, daß trotz der geringeren Abmessung der Strahlungsanteile quer zu ihrer Ausbreitungsrichtung die gesamte Strahlungs-Eintrittsfläche 7 des jeweiligen refraktiven Elements 24 ausgeleuchtet wird, wie dies anhand des mittleren refraktiven Elements 24 in Figur 11A angedeutet ist. Auf diese Weise wird auf der Seite der Strahlungs-Austrittsfläche 8 ein höherer Füllfaktor erzeugt, wie deutlicher anhand der Figur 11B dargestellt ist. Eine entsprechende Maßnahme mit reflektiven Elementen ist in Figur 12 schematisch dargestellt. In diesem Beispiel fallen die Strahlungsanteile 4 schräg auf jeweilige reflektive Flächen 25 eines Treppenstufenspiegels 26, wie durch die schrägen Linien 27 an den einfallenden Strahlungsanteilen 4 angedeutet ist, so ein, daß, verglichen mit der Breite der jeweiligen Strahlungsanteile, ein größerer Bereich der reflektiven Flächen 25 bestrahlt wird; hierdurch werden ausgangsseitig die relativen Koordinaten der einzelnen Strahlungsanteile so geändert, daß sie einen Füllfaktor von annähernd 100% aufweisen, wie anhand der durchgezogenen Linie 28 auf der Seite der Austrittsstrahlen 10 angedeutet ist. Eine solche Maßnahme kann zum Beispiel in der Ausführungsform, die in den Figuren 5A und 5B dargestellt ist, bei dem Element 17 umgesetzt werden, um den Füllfaktor der von den Spiegelflächen reflektierten Strahlen gegenüber den Eintrittsstrahlen zu erhöhen.

Während anhand der Figuren 11 und 12 nur schematisch die Erhöhung des Füllfaktors dargestellt ist, kann durch geeignete Auswahl der Einfallsrichtung der Strahlungsanteile auf die Eintrittsflächen in Bezug auf refraktive Elemente und durch geeignete Auswahl der Lage der reflektiven Flächen 25 gemäß Figur 12 auch zusätzlich der Versatz der austretenden Strahlungsanteile in Bezug auf die eintretenden Strahlungsanteile zueinander so geändert werden, daß eine gewünschte Transformation auftritt, wie dies anhand der Figuren 2 bis 5 vorstehend erläutert wurde.

Da insbesondere in Bezug auf Diodenlasern in bestimmten Anwendungsfällen hohe Leistungsdichten erforderlich sind und hierzu mehrere lineare Diodenlaserfeldanordnungen in der Fastrichtung übereinander gestapelt werden, können für solche Fälle die vorstehenden Maßnahmen zur Erhöhung des Füllfaktors wiederholt in der Fastrichtung vorgenommen werden.

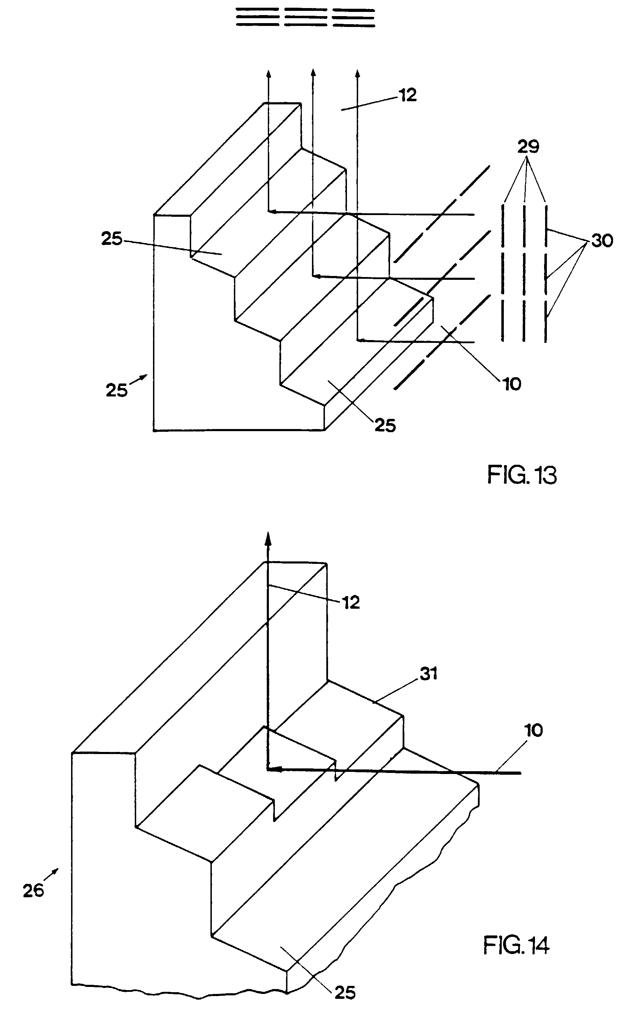

In Figur 13 ist ein schematischer Aufbau eines reflektiven Elements bzw. eines Treppenstufenspiegels 26 mit drei reflektiven Flächen 25 (entsprechend Figur 12) dargestellt. In diesem Fall ist, im Gegensatz zu der Ausführung, wie sie beispielsweise in Figur 12 dargestellt ist, jeder einzelnen reflektiven Fläche 25 eine lineare Feldanordnung 29 zugeordnet, wobei jede lineare Feldanordnung in dieser schematischen Darstellung aus drei Einzelstrahlungsquellen 30, beispielsweise einzelnen Diodenlasern, zusammengesetzt ist. Die Strahlungsanteile jeder linearen Feldanordnung 29 fallen auf jeweils eine reflektive Fläche 25 des Treppenstufenspiegels 26 unter einem vorab ausgewählten Einfallswinkel, wodurch aufgrund der Neigung der Spiegelflächen zu der Einfallsrichtung ausgangsseitig die einzelnen linearen Feldanordnungen 29 dichter zueinander geschoben werden, wie ein Vergleich des jeweiligen Strahlungsfelds einfallsseitig und austrittsseitig des Treppenstufenspiegels 26 zeigt. Mit dieser einfachen Maßnahme kann ebenfalls der Füllfaktor, in der dargestellten Ausführungsform der Figur 13 nur in einer Richtung vorgenommen, erhöht werden.

In Figur 14 ist der obere Teil des Treppenstufenspiegels 26 der Figur 13 vergrößert dargestellt. Während die einzelnen, jeder Stufe zugeordneten reflektiven Flächen 25 des Treppenstufenspiegels 26 der Figur 13 in einer Ebene liegen, ist in der Ausführungsform der Figur 14 beispielhaft eine reflektive Fläche zusätzlich abgestuft, so daß hierdurch die einzelnen Strahlungsanteile einer linearen Feldanordnung 29 aus Einzelstrahlungsquellen 30 austrittsseitig einen entsprechenden Versatz erhalten.

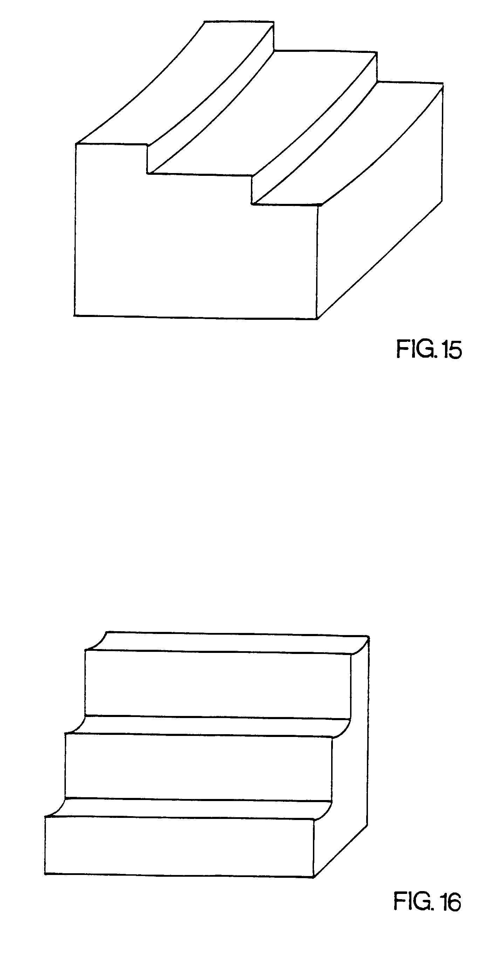

Um die einzelnen Strahlungsanteile, die auf die refraktiven oder reflektiven Elemente, die vorstehend beschrieben sind, auftreffen, zusätzlich zu fokussieren, können die einzelnen Strahlungs-Eintrittsflächen der refraktiven Elemente oder aber die Spiegelflächen der reflektiven Elemente in unterschiedlichen Richtungen konkav gewölbt werden, vorzugsweise zylindermantelförmig, wie dies die Figuren 15 und 16 zeigen.

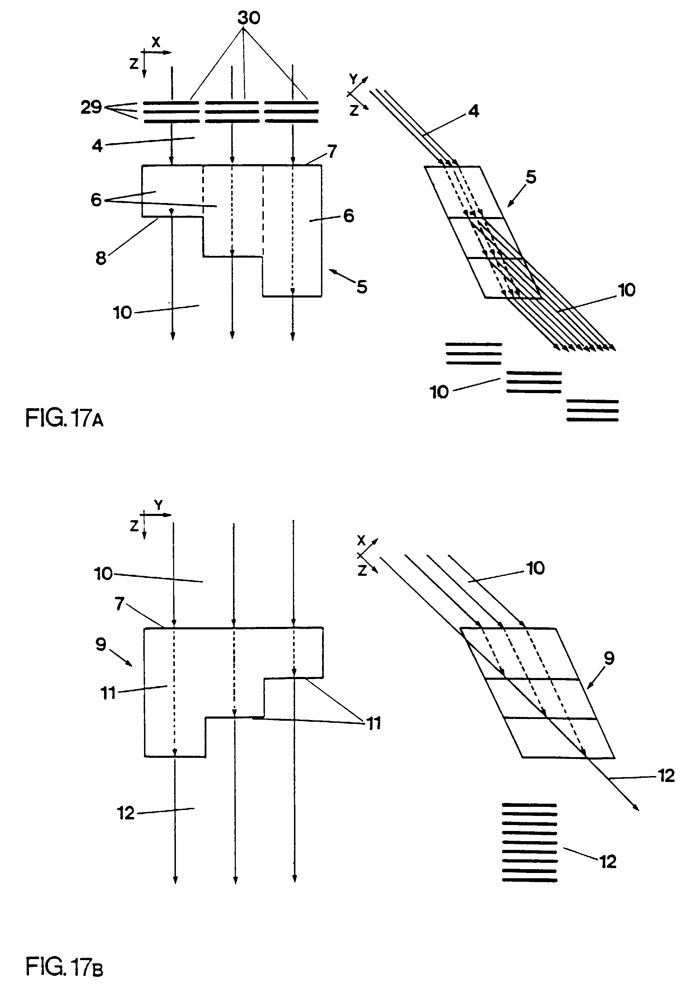

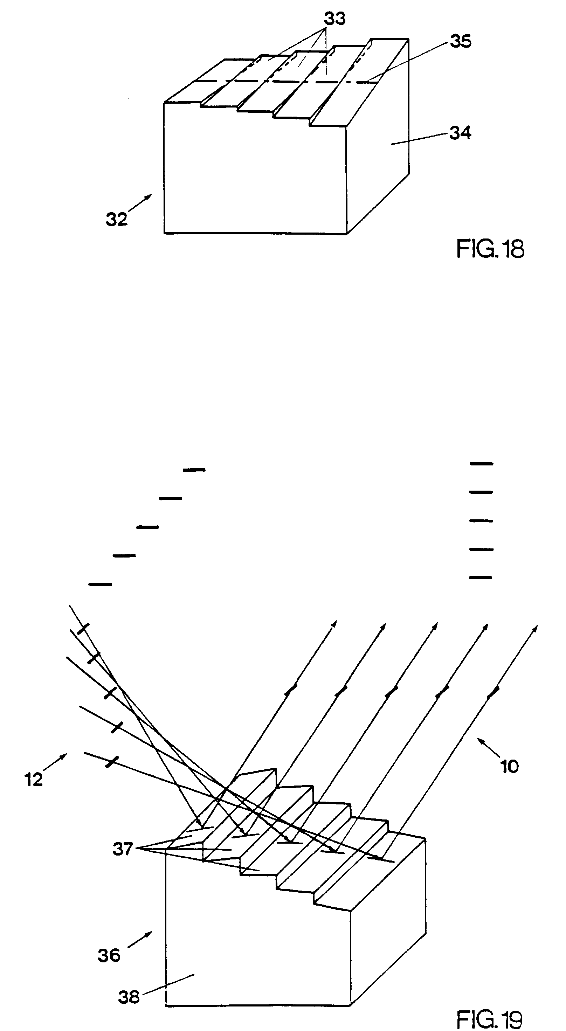

Während vorstehend anhand der Figuren 2 bis 4 verschiedene Ausführungsbeispiele dargestellt sind, bei denen unter Verwendung von ersten und zweiten refraktiven Elementen die Strahlungsanteile einer linearen Feldanordnung aus Einzelstrahlungsquellen erläutert wurde, ist in den Figuren 17A und 17B eine Ausführungsform mit einem ersten und einem zweiten Element 5, 9 mit jeweils drei ersten refraktiven Elementen 6 und drei zweiten refraktiven Elementen 9 gezeigt, in die die Strahlungsanteile von drei linearen Feldanordnungen 29 mit jeweils drei Einzelstrahlungsquellen 30 einfallen. Die Strahlung der Einzelstrahlungsquellen 30 dieser Feldanordnung wird so in Bezug auf jedes erste refraktive Element 6 gruppiert, daß jeweils die in z-Richtung untereinanderliegenden Einzelstrahlungsquellen 30 jeder in x-Richtung verlaufenden linearen Feldanordnung 29 einem refraktiven Element 6 zugeordnet werden und somit in drei Strahlungsgruppen auf die jeweiligen refraktiven Elemente einfallen. In den einzelnen refraktiven Elementen 6 werden diese Strahlungsgruppen gebrochen (in der dargestellten Ausführungsform weisen die refraktiven Elemente jeweils denselben Brechungsindex auf), wodurch aufgrund der unterschiedlich langen Ausbreitungswege in den drei refraktiven Elementen 6 die Austrittsstrahlung 10 einen treppenstufenartigen Versatz erfährt. Mit diesem Versatz werden die einzelnen Strahlungsgruppen in die zweiten refraktiven Elemente 11 eingestrahlt, die in Figur 18B dargestellt sind, und zwar derart, daß die Strahlung in einer zu der ersten Brechungsrichtung senkrechten Richtung gebrochen wird, so daß ausgangsseitig der zweiten refraktiven Elemente 11 die drei Strahlungsgruppen und damit die neun einzelnen Strahlunganteile untereinander geschoben werden, wie das Strahlungsmuster in der Figur 17B verdeutlicht.

Vorstehend wurden verschiedene Ausführungsformen erläutert, um entweder die einzelnen Strahlungsanteile zu gruppieren und umzuordnen oder aber um den Füllfaktor einer Strahlungsgruppe zu erhöhen. Es wird verständlich, daß die jeweiligen Maßnahmen, die zur Umgruppierung und zur Erhöhung des Füllfaktors dargelegt sind, in unterschiedlicher Reihenfolge und in einer unterschiedlichen Anzahl von Schritten vorgenommen werden können.

In Figur 18 ist eine weitere Ausführungsform eines Treppenstufenspiegels 32 mit sechs Spiegelflächen 33 dargestellt, wobei jede Spiegelfläche 33 einer Strahlungsgruppe zugeordnet wird. Die einzelnen Spiegelflächen 33 stehen zum einen senkrecht auf einer Ebene, die der Fläche 34 des Treppenstufenspiegels 32 entspricht, zum anderen sind sie um eine Achse 35, die durch eine unterbrochene Linie in Figur 18 angedeutet ist, zueinander um jeweils gleiche Winkel verschwenkt. Aufgrund dieser Maßnahme kann ein doppelter Versatz bzw. eine zweifache Transformation der einzelnen Strahlungsanteile zwischen der Eintrittsseite und auf der Strahlungs-Austrittsseite erreicht werden.

Entsprechend dem Treppenstufenspiegel 32, wie er in Figur 18 dargestellt ist, kann ein refraktiver Körper aufgebaut werden, wobei dann die einzelnen Spiegelflächen 33 des Treppenstufenspiegels 32 der Figur 18 den Eintritts- und/oder Austrittsflächen für die Strahlungsgruppen entsprechen.

Weiterhin können, im Gegensatz zu der Darstellung der Figur 18, die einzelnen Spiegelflächen 33 einen zusätzlichen Versatz derart aufweisen, daß die einzelnen Achsen 35, um die die einzelnen Spiegelflächen 33 zueinander verschwenkt sind, mit Abstand parallel zueinander ausgerichtet sind.

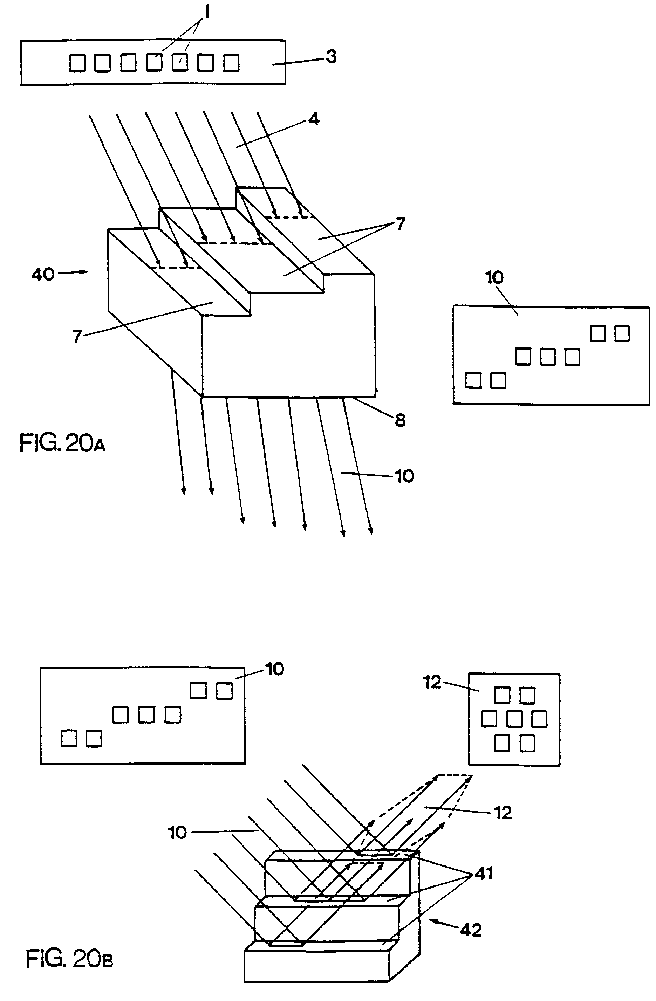

Die Figur 19 zeigt ein Beispiel eines weiteren Treppenstufenspiegels 36 mit sechs Spiegelflächen 37, die jeweils einer Strahlungsgruppe zugeordnet sind. Die einzelnen Treppenstufen-Spiegelflächen 37 stehen senkrecht auf einer Fläche 38, die der einen Seitenfläche des Treppenstufenspiegels 36 in Figur 19 entspricht, sie sind allerdings zueinander, quer zu ihrer Längserstreckung, geringfügig um einen Winkel gekippt, wobei die Längskanten, die auf der Fläche 38 senkrecht stehen, parallel zueinander ausgerichtet sind. Der jeweilige Versatz benachbarter Spiegelflächen 37 ist von rechts nach links jeweils vergrößert. Durch diese Anordnung wird erreicht, daß, ausgehend von einfallenden Strahlungsgruppen, die räumlich getrennt sind und deren Ausbreitungsrichtungen unterschiedlich sind, diese derart reflektiert werden, daß die Strahlungsgruppen in Bezug auf Diodenlaser in Fastrichtung übereinander gestapelt werden und sich in einer gemeinsamen Richtung ausbreiten. Dies gilt analog in Bezug auf Festkörperlaser.

Ein weiteres Ausführungsbeispiel zur Gruppierung und Umorientierung eines Strahlungsfelds, das von sieben linear angeordneten, einzelnen Strahlungsquellen, beispielsweise Einzeldioden 1, abgegeben wird, ist in den Figuren 20A und 20B dargestellt. Gemäß Figur 20A fallen die einzelnen Strahlungsanteile bzw. Strahlungsgruppen, die entsprechend der Anzahl der Einzeldioden 1 gruppiert sind, auf einen refraktiven Körper 40, der drei zueinander abgestufte Strahlungs-Eintrittsflächen 7 aufweist. Die Strahlungsgruppen 4 sind so gruppiert und diesen Strahlungs-Eintrittsflächen 7 zugeordnet, daß in den beiden äußeren Strahlungs-Eintrittsflächen 7 jeweils zwei der Strahlungsanteile der Einzeldioden 1 eintreten, während in die mittlere Strahlungs-Eintrittsfläche die Strahlungsanteile der entsprechenden drei mittleren Einzeldioden 1 der linearen Feldanordnung 3 eintreten. Aufgrund der unterschiedlich langen Ausbreitungswege der Strahlungsgruppen in dem refraktiven Körper 40 erhalten die einzelnen Strahlungsanteile an der Strahlungs-Austrittsfläche 8 einen Versatz zueinander, so daß ein Strahlungsmuster entsteht, wie es in Figur 20A rechts angedeutet ist. Diesem Strahlungsmuster werden nun, entsprechend den drei Strahlungsgruppierungen, drei Spiegelflächen 41 eines Treppenstufenspiegelkörpers 42 zugeordnet, wie dies die Figur 20B zeigt. Die einzelnen Spiegelflächen 41 besitzen einen solchen Versatz, daß die drei Strahlungsgruppen derart lateral zusammengeschoben werden, daß ein annähernd kreisförmiges Strahlungsfeld mit zwei-drei-zwei-Strahlungsfeldern untereinanderliegend entsteht.

Anhand dieser Figur wird ersichtlich, daß durch gezielte Umorientierung der einzelnen Strahlungsfelder durch die refraktiven und reflektiven Maßnahmen die Strahlung der Einzeldioden 1, oder aber auch einer Feldanordnung aus einzelnen linearen Einzelstrahlungsquellen, den Anforderungen entsprechend angepaßt werden können.

Weiterhin sollte ersichtlich werden, daß aufgrund der Reflexionen eine Umorientierung der einzelnen Strahlungsanteile erfolgen kann, d.h. diese Strahlungsanteile können um die Achse ihrer Ausbreitungsrichtung gedreht bzw. gespiegelt werden.

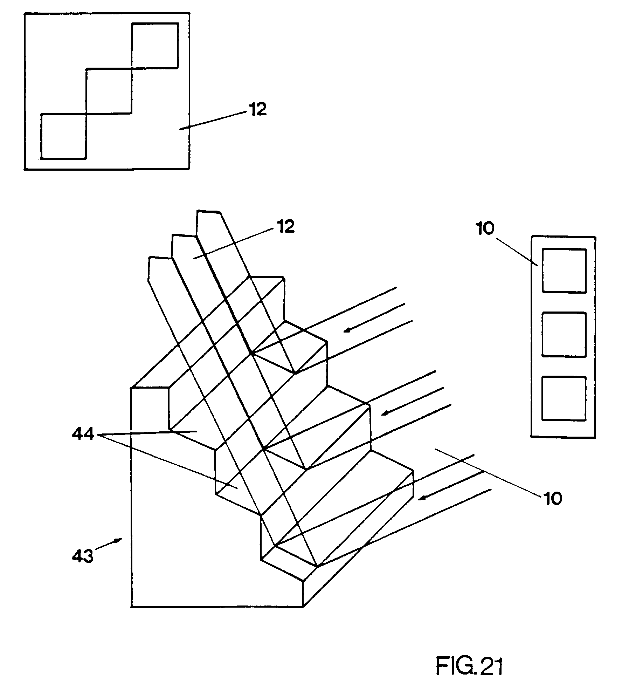

Figur 21 zeigt nochmals ein Ausführungsbeispiel mit einem Treppenstufenspiegel 43, der mit dem Treppenstufenspiegel 26 der Figur 12 vergleichbar ist. In diesem Beispiel wird gezeigt, daß durch die entsprechende Neigung der einzelnen Spiegelflächen 44 derart, daß sie eine Sägezahnform aufweisen, aus einer linearen Strahlungsfeldanordnung, wie sie rechts in Figur 21 dargestellt ist, wo die einzelnen Strahlungsquerschnitte der einzelnen Strahlungsquellen untereinander liegen und einen Abstand zueinander besitzen, eine solche Umorientierung erfolgen kann, daß diese Strahlungsquerschnittsflächen auf einer Diagonalen liegen und aneinander angrenzen, wie dies in Figur 21 links oben gezeigt ist. Mit dieser Anordnung wird ausgangsseitig, verglichen mit der Eintrittsseite, der Füllfaktor erhöht, gleichzeitig aber auch ein Versatz erreicht.

## Patentansprüche

1. Anordnung zur Formung und Führung eines Strahlungsfelds eines oder mehrerer Festkörper- und/oder Halbleiterlaser(s), insbesondere eines Strahlungsfelds eines Arrays bzw. einer Feldanordnung aus einem oder mehreren Festkörper- und/oder Halbleiterlaser(n), mit einer Strahlungstransformationsoptik zur Erzeugung eines definierten Strahlungsfelds, wobei die Optik refraktive Elemente aufweist, dadurch gekennzeichnet, daß das Strahlungsfeld (4) in mindestens zwei Strahlungsgruppen gemäß einer Vorgabe gruppiert ist und jede Strahlungsgruppe mit vorgegebenen Koordinaten in ein ihr zugeordnetes refraktives Element (6; 15; 19; 21; 23; 24) eintritt, wobei jedes refraktive Element (6; 15; 19; 21; 23; 24) die jeweilige Strahlungsgruppe an mindestens einer seiner Flächen (7) derart bricht, daß die Strahlungsgruppen mit relativ zueinander geänderten Ausgangs-Koordinaten und/oder Ausgangs-Ausbreitungsrichtungen aus den refraktiven Elementen (6; 15; 19; 21; 23; 24) derart austreten, daß das genannte Strahlungsfeld zu einem Strahlungsfeld einer gewünschten Anordnung und Verteilung der Leistungsdichte transformiert ist.

2. Anordnung nach Anspruch 1, dadurch gekennzeichnet, daß die aus den refraktiven Elementen (6; 15; 19; 21; 23; 24) austretende Strahlung (10) gruppiert und jede Strahlungsgruppe in ein ihr zugeordnetes weiteres refraktives Element (11; 16; 19; 21; 23; 24) eintritt, wobei jedes weitere refraktive Element (11; 16; 19; 21; 23; 24) die jeweilige Strahlungsgruppe an mindestens einer seiner Flächen derart bricht, daß die Strahlungsgruppen mit gegenüber ihren relativen lateralen Eingangs-Koordinaten relativ zueinander geänderten Ausgangs-Koordinaten und/oder AusgangsAusbreitungsrichtungen aus den weiteren refraktiven Elementen (11; 16; 19; 21; 23; 24) austreten.

3. Anordnung nach Anspruch 1 oder 2, dadurch gekennzeichnet, daß die einzelnen Strahlungsgruppen unterschiedlich lange Ausbreitungswege in den refraktiven Elementen (11; 16; 19; 21; 23; 24) jeweils durchlaufen.

4. Anordnung nach Anspruch 3, dadurch gekennzeichnet, daß unmittelbar benachbarte Strahlungsgruppen gleiche Differenzen ihrer Ausbreitungswege aufweisen.

5. Anordnung nach einem der Ansprüche 1 bis 4, dadurch gekennzeichnet, daß wenigstens ein Teil der refraktiven Elemente (21) zueinander unterschiedliche Brechungsindizes aufweist.

6. Anordnung nach Anspruch 4 oder 5, dadurch gekennzeichnet, daß einzelne, benachbarte refraktive Elemente (14) voneinander durch eine Schicht (20) getrennt sind, die einen gegenüber dem angrenzenden refraktiven Element geringeren Brechungsindex aufweist.

7. Anordnung nach einem der Ansprüche 1 bis 6, dadurch gekennzeichnet, daß die Eintritts- und/oder Austrittsflächen der einzelnen refraktiven Elemente senkrecht auf einer gemeinsamen Ebene stehen und zueinander unterschiedlich geneigt sind.

8. Anordnung nach einem der Ansprüche 1 bis 7, dadurch gekennzeichnet, daß bei Strahlungsgruppen, deren jeweilige Querschnittsabmessungen ihrer Strahlungsanteile kleiner als die Breite des zugeordneten refraktiven Elements (24) ist, die jeweilige Strahlungsgruppe in die Eintrittsfläche (7) des jeweiligen refraktiven Elements (24) unter einem Einfallswinkel ungleich 0° derart eintritt, daß annähernd die gesamte Breite der Eintrittsfläche (7) des refraktiven Elements (24) ausgeleuchtet ist.

9. Anordnung nach Anspruch 8, dadurch gekennzeichnet, daß mehrere streifenförmige Strahlungsfelder (29) parallel zueinander angeordnet sind.

10. Anordnung nach einem der Ansprüche 8 oder 9, dadurch gekennzeichnet, daß jedes streifenförmige Strahlungsfeld (29) aus einer gleichen Anzahl von Strahlungsgruppen (30) gebildet ist.

11. Anordnung nach Anspruch 1, dadurch gekennzeichnet, daß die aus den refraktiven Elementen austretende Strahlung gruppiert und jede Strahlungsgruppe auf ein ihr zugeordnetes reflektives Element (18; 25; 33; 37; 41; 44) mit einer Reflexionsfläche gerichtet ist, wobei die Reflexionsflächen einen Versatz und/oder eine Verkippung derart zueinander aufweisen, daß die Strahlungsgruppen mit gegenüber ihren Eintrittskoordinaten relativ zueinander geänderten Koordinaten und/oder Ausbreitungsrichtungen und/oder Orientierungen von den Reflexionsflächen abgestrahlt werden.

12. Anordnung nach Anspruch 11, dadurch gekennzeichnet, daß der jeweilige Versatz und die jeweilige Abstandsänderung benachbarter Reflexionsflächen von gleicher Größe sind.

13. Anordnung nach einem der Ansprüche 11 oder 12, dadurch gekennzeichnet, daß die Reflexionsflächen durch einen treppenstufenartig aufgebauten ersten Spiegel (17; 26; 32; 36; 42; 43) gebildet sind.

14. Anordnung nach einem der Ansprüche 1 bis 13, dadurch gekennzeichnet, daß die Reflexionsflächen ebene Flächenbereiche sind.

15. Anordnung nach einem der Ansprüche 11 bis 14, dadurch gekennzeichnet, daß bei Strahlungsgruppen, deren jeweilige Querschnittsabmessungen ihrer Strahlungsanteile kleiner als die Breite des zugeordneten reflektiven Elements (26) ist, die jeweilige Strahlungsgruppe auf die Reflexionsfläche (25) des jeweiligen reflektiven Elements unter einem Einfallswinkel ungleich 0° derart auftrifft, daß annähernd die gesamte Breite der Reflexionsfläche (25) des reflektiven Elements (26) ausgeleuchtet ist.

16. Anordnung nach einem der Ansprüche 11 bis 15, dadurch gekennzeichnet, daß die einzelnen reflektiven Elemente (37) senkrecht auf einer gemeinsamen Ebene (38) stehen und zueinander unterschiedlich geneigt sind.

17. Verfahren zur Formung und Führung eines Strahlungsfelds eines oder mehrerer Festkörper- und/oder Halbleiterlaser(s), insbesondere eines Strahlungsfelds eines Arrays bzw. einer Feldanordnung aus einem oder mehreren Festkörper- und/oder Halbleiterlaser(n), mit einer Strahlungstransformationsoptik zur Erzeugung eines definierten Strahlungsfelds, wobei die Optik refraktive Elemente aufweist, dadurch gekennzeichnet, daß das Strahlungsfeld in mindestens zwei Strahlungsgruppen gemäß einer Vorgabe gruppiert wird, daß jede so gebildete Strahlungsgruppe mit vorgegebenen Koordinaten in ein ihr zugeordnetes erstes refraktives Element eingestrahlt wird, wobei in jedem refraktiven Element die jeweilige Strahlungsgruppe an mindestens einer seiner Flächen derart gebrochen wird, daß die aus den ersten refraktiven Elementen austretenden Strahlungsgruppen in einer ersten Richtung gegenüber der eingestrahlten Richtung derart versetzt zueinander sind, daß das genannte Strahlungsfeld zu einem Strahlungsfeld einer gewünschten Anordnung und Verteilung der Leistungsdichte transformiert ist.

18. Verfahren nach Anspruch 17, dadurch gekennzeichnet, daß die aus den ersten refraktiven Elementen austretenden Strahlungsanteile gruppiert und jede dieser Strahlungsgruppen in ein ihr zugeordnetes zweites refraktives Element eingestrahlt werden, wobei in jedem zweiten refraktiven Element die jeweilige Strahlungsgruppe an mindestens einer seiner Flächen derart gebrochen wird, daß die aus den zweiten refraktiven Elementen austretenden Strahlungsgruppen gegenüber der ersten Richtung in einer zweiten Richtung zueinander versetzt austreten.

19. Verfahren nach einem der Ansprüche 17 oder 18, dadurch gekennzeichnet, daß die Strahlungsgruppen in dem ersten refraktiven Element in einer Richtung gebrochen werden, die eine wesentliche Richtungskomponente senkrecht zur größten Erstreckung der Feldanordnung bzw. des Strahlungsfelds besitzen.

20. Verfahren nach Anspruch 17, dadurch gekennzeichnet, daß die Strahlungsgruppen in dem refraktiven Element in einer Richtung gebrochen werden, die eine wesentliche Richtungskomponente senkrecht zur größten Erstreckung der Feldanordnung bzw. des Strahlungsfeldes besitzt.

21. Verfahren nach einem der Ansprüche 18 bis 20, dadurch gekennzeichnet, daß die Strahlungsanteile derart transformiert werden, daß die aus dem letzten Element austretenden Strahlungsgruppen zueinander parallele Ausbreitungsrichtungen haben.

## Claims

1. Arrangement for forming and guiding a radiation field of one or several solid and/or semiconductor laser(s), especially a radiation field of an array or a field layout consisting of one or several solid and/or semiconductor laser(s), with a radiation transformation lens system for generating a defined radiation field, the lens system having refractive elements, **characterised in that** the radiation field (4) is grouped into at least two radiation groups according to a pre-setting and each radiation group with preset co-ordinates enters a refractive element (6;15;19;21;23;24) allocated to it, each refractive element (6;15;19;21;23;24) refracting the respective radiation group on at least one of its surfaces (7) in such a way that the radiation groups emerge from the refractive elements (6;15;19;21;23;24) with exit co-ordinates and/or exit propagation directions altered relative to one another, in such a way that the mentioned radiation field is transformed into a radiation field which has a desired layout and distribution of power density.

2. Arrangement according to claim 1, **characterised in that** the radiation (10) emerging from the refractive elements (6;15;19;21;23;24) is grouped and each radiation group enters an additional refractive element (11;16;19;21;23;24) allocated to it, each additional refractive element [11;16;19;21;23;24) refracting on at least one of its surfaces in such a way that the radiation groups emerge from the additional refractive elements (11;16;19;21;23;24) with exit co-ordinates and/or exit propagation directions altered relative to one another in relation to their lateral entry co-ordinates.

3. Arrangement according to lain 1 or 2, **characterised in that** the individual radiation groups respectively pass through propagation paths of differing lengths in the refractive elements (11;16;19;21;23;24).

4. Arrangement according to claim 3, **characterised in that** directly adjacent radiation groups have the same differences of their propagation paths.

5. Arrangement according to one of claims 1 to 4, **characterised in that** at least a part of the refractive elements (21) have different refractive indices from one another.

6. Arrangement according to claim 4 or 5, **characterised in that** individual, adjacent refractive elements (14) are separated from one another by a layer (20) which has a lower refractive index than the adjacent refractive element.

7. Arrangement according to one of claims 1 to 6, **characterised in that** the entry and/or exit surfaces of the individual refractive elements lie perpendicularly on a common plane and are inclined differently to one another

8. Arrangement according to one of claims 1 to 7, **characterised in that**, with radiation groups whose respective cross-sectional dimension of their radiation portions is smaller than the width of the associated refractive element (24), the respective radiation group enters the entry surface (7) of the respective refractive element (24) at an angle of incidence not equal to 0°, in such a way that approximately the whole width of the entry surface (7) of the refractive element (24) is illuminated.

9. Arrangement according to claim 8, **characterised in that** a plurality of strip-shaped radiation fields (29) are disposed parallel to one another.

10. Arrangement according to one of claims 8 or 9, **characterised in that** each strip-shaped radiation field (29) is formed from the same number of radiation groups (30).

11. Arrangement according to claim 1, **characterised in that** the radiation emerging from the refractive elements is grouped and each radiation group is directed onto an associated reflective element (18;25;33;37;41;44) with a reflecting surface, the reflecting surfaces being offset or tilted in relation to one another in such a way that the radiation groups are reflected from the reflecting surfaces with altered co-ordinates and/or propagation directions and/or orientations relative to one another in relation to their entry co-ordinates.

12. Arrangement according to claim 11, **characterised in that** the respective offset and the respective alteration in spacing between adjacent reflecting surfaces are of the same size.

13. Arrangement according to one of claims 11 or 12, **characterised in that** the reflecting surfaces are formed by a first mirror (17;26;32;36;42;43) constructed like a stair-step.

14. Arrangement according to one of claims 1 to 13, **characterised in that** the reflecting surfaces are flat surface regions.

15. Arrangement according to one of claims 11 to 14, **characterised in that**, with radiation groups whose respective cross-sectional dimension of their radiation portion is smaller than the width of the associated reflective element (26), the respective radiation group impinges on the reflecting surface (25) of the respective reflective element at an angle of incidence not equal to 0°, in such a way that approximately the whole width of the reflecting surface (25) of the reflective element (26) is illuminated.

16. Arrangement according to one of claims 11 to 15, **characterised in that** the individual reflective elements (37) lie perpendicularly on a common plane (38) and are differently inclined to one another.

17. Method for forming and guiding a radiation field of one or several solid and/or semiconductor laser(s), especially a radiation field of an array or a field layout consisting of one or several solid and/or semiconductor laser(s), with a radiation transformation lens system for generating a defined radiation field, the lens system having refractive elements, **characterised in that** the radiation field (4) is grouped into at least two radiation groups according to a pre-setting, in that each radiation group so formed with preset co-ordinates is radiated into a first associated refractive element, the respective radiation group being refracted in each refractive element on at least one of its surfaces in such a way that the radiation groups emerging from the first refractive elements are offset in a first direction in relation to the radiated direction, in such a way that the mentioned radiation field is transformed into a radiation field with a desired layout and distribution of the power density.

18. Method according to claim 17, **characterised in that** the radiation portions emerging from the first refractive elements are grouped and each of these radiation groups is radiated into an associated second refractive element, the respective radiation group in each second refractive element being refracted on at least one of its surfaces in such a way that the radiation groups emerging from the second refractive elements emerge offset to one another in a second direction in relation to the first direction.

19. Method according to one of claims 17 or 18, **characterised in that** that the radiation groups in the first refractive element are refracted in a direction which has a substantial direction component perpendicular to the largest extension of the field layout or of the radiation field.

20. Method according to claim 17, **characterised in that** the radiation groups in the refractive element are refracted in a direction which has a substantial direction component perpendicular to the largest extension of the field layout or of the radiation field.

21. Method according to one of claims 18 to 20, **characterised in that** the radiation portions are transformed in such a way that the radiation groups emerging from the last element have propagation directions parallel to one another.

## Revendications

1. Disposition pour former et guider un champ de rayonnement d'un ou plusieurs lasers à corps solide et/ou à semiconducteur notamment un champ de rayonnement d'un réseau ou d'une disposition de champs, formée d'un ou plusieurs lasers à corps solide et/ou semi-conducteur, comprenant :
- une optique de transformation de rayonnement pour générer un champ de rayonnement déterminé,
- l'optique ayant des éléments réfractants,
caractérisée en ce que
le champ de rayonnement (4) est groupé selon une indication préalable selon au moins deux groupes de rayonnement et chaque groupe de rayonnement avec des coordonnées prédéterminées, arrive dans un élément réfractant associé (6, 15, 19, 21, 23, 24),
chaque élément réfractant (6, 15, 19, 21, 23, 24) assure la réfraction du groupe de rayonnement respectif sur au moins une de ses surfaces (7) pour que les groupes de rayonnement sortent avec des coordonnées de sortie modifiées de manière relative et/ou des directions de réfraction de sortie des éléments réfractants (6, 15, 19, 21, 23, 24) de façon que le champ de rayonnement soit transformé en un champ de rayonnement avec une disposition et une répartition souhaitée de la densité de puissance.

2. Disposition selon la revendication 1,
caractérisée en ce que
le rayonnement (10) sortant des éléments réfractants (6, 15, 19, 21, 23, 24) est groupé et chaque groupe de rayonnement arrive dans un autre élément réfractant (11, 16, 19, 21, 23, 24) qui lui est associé,
chaque autre élément réfractant (11, 16, 16, 21, 23, 24) assure la réfraction du groupe de rayonnement respectif sur au moins l'une de ses surfaces pour que les groupes de rayonnement sortent avec des coordonnées de sortie modifiées de manière relative par rapport aux coordonnées d'entrée relatives et/ou des directions d'extension des autres éléments réfractants (11, 16, 19, 21, 23, 24).

3. Disposition selon la revendication 1 ou 2,
caractérisée en ce que
les différents groupes de rayonnement parcourent des chemins d'extension de longueur différente dans les éléments réfractants (11, 16, 19, 21, 23, 24).

4. Disposition selon la revendication 3,
caractérisée en ce que
des groupes de rayonnement directement voisins ont des différences égales pour les chemins d'extension.

5. Disposition selon l'une des revendications 1 à 4,
caractérisée en ce qu'
au moins une partie des éléments réfractants (21) présente des indices de réfraction différents.

6. Disposition selon la revendication 4 ou 5,
caractérisée en ce que
les différents éléments réfractants voisins (14) sont séparés les uns des autres par une couche (20) ayant un indice de réfraction inférieur à celui de l'élément réfractant adjacent.

7. Disposition selon l'une des revendications 1 à 6,
caractérisée en ce que
les surfaces d'entrée et/ou de sortie des différents éléments réfractants sont perpendiculaires à plan commun et sont inclinées de manière différente les unes par rapport aux autres.

8. Disposition selon l'une des revendications 1 à 7,
caractérisée en ce que
pour des groupes de rayonnement dont les dimensions de section respectives de leurs composantes de rayonnement sont inférieures à la largeur de l'élément réfractant (24) associé, le groupe de rayonnement respectif pénètre dans la surface d'entrée (7) de l'élément réfractant (24) respectif sous un angle d'incidence différent de 0° pour que pratiquement l'ensemble de la largeur de la surface d'entrée (7) de l'élément réfractant (24) soit exposé.

9. Disposition selon la revendication 8,
caractérisée par
plusieurs champs de rayonnement (29) en forme de bandes parallèles les uns aux autres.

10. Disposition selon l'une des revendications 8 ou 9,
caractérisée en ce que
chaque champ de rayonnement (29) en forme de bande est composé d'un même nombre de groupes de rayonnement (30).

11. Disposition selon la revendication 1,
caractérisée en ce que
le rayonnement sortant des éléments réfractants et chaque groupe de rayonnement est dirigé sur un élément réfléchissant associé (18, 25, 33, 37, 41, 44) ayant une surface réfléchissante, les surfaces réfléchissantes étant décalées et/ou basculées les unes par rapport aux autres, les groupes de rayonnement étant émis avec des coordonnées modifiées par rapport aux coordonnées d'entrée et/ou des directions de réfraction et/ou des orientations des surfaces de réflexion.

12. Disposition selon la revendication 11,
caractérisée en ce que
le décalage respectif et la variation de distance respective de surfaces de réflexion voisines est de même amplitude.

13. Disposition selon l'une des revendications 11 ou 12,
caractérisée en ce que
les surfaces de réflexion sont formées par un premier miroir (17, 26, 32, 36, 42, 43) réalisé en forme de gradins.

14. Disposition selon l'une des revendications 1 à 13,
caractérisée en ce que
les surfaces de réflexion sont des zones de surfaces planes.

15. Disposition selon l'une des revendications 1 à 14,
caractérisée en ce que
pour les groupes de rayonnement les dimensions des sections respectives de leurs composantes de rayonnement sont plus petites que la largeur de l'élément réfléchissant (26) associé, et le groupe de rayonnement respectif arrive sur la surface de réflexion (25) de l'élément réfléchissant respectif sous un angle d'incidence différent de 0° pour qu'au moins approximativement, toute la largeur de la surface réfléchissante (25) de l'élément réfléchissant (26) soit exposée.

16. Disposition selon l'une des revendications 11 à 15,
caractérisée en ce que
les différents éléments réfléchissants (37) sont perpendiculaires à un plan commun (38) et son inclinés différemment les uns par rapport aux autres.

17. Procédé pour former et guider un champ de rayonnement d'un ou plusieurs lasers à corps solide et/ou semiconducteur, notamment un champ de rayonnement d'un réseau ou d'une disposition de champs formée d'un ou plusieurs lasers à corps solide et/ou semi-conducteur, comprenant une optique de transformation de rayonnement pour générer un champ de rayonnement déterminé,
l'optique comportant des éléments de réfraction,
caractérisé en ce que
le champ de rayonnement est regroupé en au moins deux groupes de rayonnement selon une indication prédéterminée,
chaque groupe de rayonnement ainsi formé étant induit selon des coordonnées prédéterminées dans un premier élément réfractant associé,
dans chaque élément réfractant, le groupe de rayonnement respectif est réfracté sur au moins l'une des surfaces de façon que les groupes de rayonnement sortant des premiers éléments réfractants soient décalés dans une première direction par rapport à la direction d'incidence de façon que l'ensemble du champ de rayonnement soit transformé en un champ de rayonnement ayant une disposition et une répartition souhaitées de la densité lumineuse.

18. Procédé selon la revendication 17,
caractérisé en ce que
les composantes de rayonnement sortant des premiers éléments réfractants sont groupées et chacun de ces groupes de rayonnement arrive dans un second élément réfractant associé,
et dans chaque second élément réfractant, le groupe de rayonnement respectif est réfracté sur au moins l'une des surfaces de façon que les groupes de rayonnement sortant des seconds éléments réfractants soient décalés dans une deuxième direction par rapport à la première direction.

19. Procédé selon l'une des revendications 17 ou 18,
caractérisé en ce que
les groupes de rayonnement dans le premier élément réfractant sont réfractés dans une direction qui a une composante directionnelle essentiellement perpendiculaire à la plus grande extension de la disposition de champs ou du champ de rayonnement.

20. Procédé selon la revendication 17,
caractérisé en ce que
les groupes de rayonnement sont réfractés dans leur direction dans l'élément réfractant, pour avoir une composante directionnelle principale perpendiculaire à la plus grande extension de la disposition de champs ou du champ de rayonnement.

21. Procédé selon l'une des revendications 18 à 20,
caractérisé en ce que
les composantes de rayonnement sont transformées pour que les groupes de rayonnement sortant du dernier élément possèdent des directions d'extension parallèles.
